# EUROPEAN PATENT APPLICATION

(11) **EP 4 478 858 A1**
(43) Date of publication of application: **18.12.2024**
(21) Application number: 23769923.6
(22) Date of filing: 17.03.2023
(51) Int. Cl.: H10B 51/50

(54) **THREE-DIMENSIONAL MEMORY AND PREPARATION METHOD THEREFOR, STORAGE SYSTEM, AND ELECTRONIC DEVICE**

(30) Priority: 18.03.2022 CN 202210273522; 18.03.2022 CN 202210273515
(71) Applicant: Yangtze Memory Technologies Co., Ltd., Wuhan, Hubei 430000 (CN)
(72) Inventor: ZHANG, Zhong, Wuhan, Hubei 430000 (CN); WANG, Di, Wuhan, Hubei 430000 (CN); ZHOU, Wenxi, Wuhan, Hubei 430000 (CN); ZHANG, Kun, Wuhan, Hubei 430000 (CN); XIA, Zhiliang, Wuhan, Hubei 430000 (CN); HUO, Zongliang, Wuhan, Hubei 430000 (CN)
(74) Representative: Lippert Stachow Patentanwälte Rechtsanwälte
(86) International application number: PCT/CN2023/082250
(87) International publication number: WO 2023/174421

(57) **Abstract**

The present disclosure provides a three-dimensional memory and a fabrication method thereof, a memory system and an electronic apparatus. The three-dimensional memory includes a stack structure, a plurality of first stops disposed in the first direction X, a protection layer and a plurality of contact posts. The stack structure includes a step structure including a plurality of staircase structures disposed in the first direction and having different heights in a second direction. A plurality of first stops are located on the plurality of steps of at least one staircase structure. The protection layer covers the step structure and the first stops and at least a part of the protection layer is located between the first stop and the step adj acent to the first stop. The contact post extends through the protection layer and the first stop and is connected with gate layer in the step corresponding to the first stop.

## Description

### CROSS-REFERENCE TO RELATED APPLICATIONS

The present disclosure is filed based on Chinese patent application No. 202210273522.3 filed on March 18 2022, and Chinese patent application No. 202210273515.3 filed on March 18 2022 and claims priority of these two Chinese patent applications, which are incorporated herein by reference in their entirety.

### TECHNICAL FIELD

The present disclosure relates to the field of semiconductor chip technology, in particular to a three-dimensional memory and a fabrication method thereof, a memory system and an electronic apparatus.

### BACKGROUND

As the feature sizes of memory cells approach the lower limit of process, planar process and manufacturing techniques have become challenging and expensive, resulting in the memory density of 2D or planar NAND flashes approaching the upper limit. In order to overcome limitations brought by 2D or planar NAND flashes, a memory with three-dimensional structure (3D NAND) have been developed in the industry, which improves the memory density by arranging memory cells on a substrate in three dimensions.

In practical fabrication process of a three-dimensional memory, in order to implement the electrical connections between contacts and gate layers in the stack structure, contact holes exposing respective gate layers in the staircase region need to be formed in the dielectric layer covering the stack structure and then a conductive material is filled in the contact holes to form the contacts.

However, as the integration level of the three-dimensional memory increases and the number of stacked layers increases, the depth of the contact hole increases more and more, resulting in the gate layers in higher layers being etched through in the process of forming the contact holes. In this case, after filling the conductive material for forming the contacts in the contact holes, shorting among different gate layers (namely electrical connections among word lines in different layers) might be caused, thereby resulting failure of the memory.

### SUMMARY

Examples of the present disclosure provide a three-dimensional memory and a fabrication method thereof, a memory system and an electronic apparatus.

Examples of the present disclosure adopt the following technical solutions.

In an aspect, there is provided a three-dimensional memory. The three-dimensional memory includes a stack structure, a plurality of first stops disposed in a first direction, a protection layer and a plurality of contact posts. The stack structure includes gate layers and dielectric layers disposed alternately. The stack structure includes a step structure including a plurality of staircase structures disposed in the first direction and having different heights in a second direction. The staircase structure includes a plurality of steps. The first direction and the second direction are perpendicular to each other. The plurality of first stops disposed in the first direction are located on the plurality of steps of at least one of the staircase structures, with each of the first stops disposed on one of the steps. The protection layer covers the step structures and the first stops, at least a part of the protection layer is located between the first stop and the step adjacent to the first stop. The contact post extends through the protection layer and the first stop and is connected with the gate layer in the step corresponding to the first stop.

In some examples, the three-dimensional memory further includes isolation structures extending in the first direction and through the stack structure. The isolation structures divide the stack structure into a plurality of memory blocks, each of which includes the step structure; wherein the staircase structures where the first stops are located are disposed at intervals with the isolation structures.

In some examples, in the second direction, the memory block comprises a first staircase structure, a second staircase structure and a third staircase structure, with the first stops disposed on the plurality of steps of the second staircase structure.

In some examples, in the second direction, the memory block comprises a first staircase structure and a second staircase structure, the first staircase structure disposed at intervals with the isolation structure, and the first stops being disposed on the plurality of steps of the first staircase structure.

In some examples, each memory block further includes a sidewall 16; the isolation structures include a first isolation structure and a second isolation structure; in the second direction, the first isolation structure is located between two adjacent sidewalls, the second isolation structure is located between two adjacent step structures; and in the second direction, the step structures in two memory blocks adj acent to the second isolation structure are disposed symmetrically.

In some examples, in the second direction, and along a direction from the first isolation structure toward the second isolation structure, the plurality of staircase structures in the memory block have heights decreasing gradually.

In some examples, in the second direction, two staircase structures adjacent to both sides of the second isolation structure have the same heights.

In some examples, the three-dimensional memory further includes a plurality of second stops disposed in the first direction. The plurality of second stops disposed in the first direction are located on the plurality of steps of other staircase structures among the plurality of staircase structures other than the staircase structures on which the first stops are disposed. The protection layer further covers the second stops and at least a part of the protection layer is located between the second stop and the step adjacent to the second stop.

In some examples, the three-dimensional memory further includes a plurality of gate line isolation structures extending in the first direction. The plurality of gate line isolation structures extending in the first direction are located between adjacent two of the isolation structures, and the gate line isolation structure extends through the second stop and the stack structure. Along the first direction, each gate line isolation structure includes a plurality of sub isolation structures separated from each other. A material for the second stop is same as a material for the gate layer.

In some examples, the material for the second stop is same as a material for the first stop.

In some examples, the material for the first stop includes silicon nitride.

In some examples, in a third direction, a thickness of the first stop is same as a thickness of the gate layer of a previous step; the previous step being adjacent to and higher than the step corresponding to the first stop; wherein the third direction is perpendicular to the stack structure.

In another aspect, there is provided a fabrication method of a three-dimensional memory, including:
forming an initial stack structure, wherein the initial stack structure includes sacrificial layers and dielectric layers disposed alternately, the initial stack structure includes a step structure including a plurality of staircase structures disposed in a first direction and having different heights in a second direction, and the staircase structure includes a plurality of steps, with the first direction and the second direction being perpendicular to each other;
forming a plurality of first stops on the plurality of steps of at least one of the staircase structures, wherein the plurality of first stops are disposed in the first direction and each of the first stops is disposed on one of the steps;
forming a protection layer, wherein the protection layer covers the step structure and the first stop, and at least a part of the protection layer is located between the first stop and the step adjacent to the first stop;
replacing the sacrificial layers with gate layers to form a stack structure; and
forming a plurality of contact posts extending through the protection layer and the first stop and electrically connected with the gate layer in the step corresponding to the first stop.

In some examples, said forming a plurality of first stops on the plurality of steps of at least one of the staircase structures includes: etching the uppermost sacrificial layer and dielectric layer of each step to form the plurality of first stops.

In some examples, the fabrication method further includes: forming a first slit extending in the first direction and through the initial stack structure; the first slit dividing the initial stack structure into a plurality of initial memory blocks, each of which includes the step structure. An isolation structure is formed in the first slit.

In some examples, the fabrication method further includes: forming a second isolation sub portion extending in the first direction and through the initial stack structure; forming a first sub slit, a second sub slit and a second slit extending in the first direction and through the initial stack structure; wherein the first sub slit and the second sub slit contact both ends of the second isolation sub portion respectively in the first direction; and the second slit is located between two adjacent second isolation sub portions in the second direction. A first isolation sub portion is formed in the first sub slit, a third isolation sub portion is formed in the second sub slit, and a second isolation structure is formed in the second slit. The first isolation sub portion, the third isolation sub portion and the second isolation sub portion constitute at least a part of the first isolation structure.

In some examples, the fabrication method further includes: forming a plurality of second stops on the plurality of steps of other staircase structures among the plurality of staircase structures other than the staircase structures on which the first stops are disposed; each second stop is disposed on one step.

In some examples, the fabrication method further includes: forming a plurality of third slits extending in the first direction; the third slit extending through the second stop and the initial stack structure; wherein each of the third slits comprises a plurality of third sub slits separated from each other in the first direction. Gate line isolation structures are formed in the third slits.

In some examples, said forming the plurality of contact posts includes: etching the protection layer to the first stops to form a plurality of contact holes; etching the first stops exposed by the contact holes and etching the dielectric layers under the first stops to make the contact holes exposing the gate layers; and forming contact posts in the contact holes.

In yet another aspect, there is provided a memory system. The memory system includes a controller and the three-dimensional memory of any one of the above-described examples. The controller is coupled to the three-dimensional memory and configured to control the three-dimensional memory to store data.

In yet another aspect, there is provided an electronic apparatus. The electronic apparatus includes the memory system as described in any of the above examples.

### BRIEF DESCRIPTION OF DRAWINGS

In order to illustrate technical solutions in the present disclosure more clearly, drawings needed in some examples of the present disclosure will be briefly introduced. Apparently, drawings in the following description are only drawings for some examples of present disclosure, and for those skilled in the art, other drawings can be obtained from these drawings. Furthermore, the drawings described below may be regarded as illustrative diagrams, which is not a limitation to the practical sizes of products, practical flows of methods and practical timings of signals involved in examples of the present disclosure.
Fig. 1 is a perspective structure diagram of a three-dimensional memory according to some examples;
Fig. 2 is a structure diagram of contact posts and steps in the related art;
Fig. 3 is another structure diagram of contact posts and steps in the related art;
Fig. 4 is a structure diagram of a contact post according to some examples;
Fig. 5A is a top view of a three-dimensional memory according to some examples;
Fig. 5B is a top view of a three-dimensional memory according to some examples;
Fig. 6 is an enlarged view of CC region in Fig. 5A;
Fig. 7A is a cross-sectional view along the section line D-D' in Fig. 6;
Fig. 7B is another cross-sectional view along the section line D-D' in Fig. 6;
Fig. 8 is a cross-sectional view along the section line E-E' in Fig. 6;
Fig. 9 is another cross-sectional view along the section line E-E' in Fig. 6;
Fig. 10 is another enlarged view of CC region in Fig. 5A;
Fig. 11 is a cross-sectional view along the section line F-F' in Fig. 10;
Fig. 12A is a structure diagram of a step structure according to some examples;
Fig. 12B is a structure diagram of another step structure according to some examples;
Fig. 13 is yet another enlarged view of CC region in Fig. 5A;
Fig. 14 is still another enlarged view of CC region in Fig. 5A;
Fig. 15 is a cross-sectional view along the section line G-G' in Fig. 14;
Fig. 16 is a structure diagram of a memory string according to some examples;
Fig. 17 is an equivalent circuit diagram of a memory string in Fig. 16;
Fig. 18 is still another enlarged view of CC region in Fig. 5A;
Fig. 19A is a cross-sectional view along the section line H-H' in Fig. 18;
Fig. 19B is another cross-sectional view along the section line H-H' in Fig. 18;
Fig. 20 is a cross-sectional view along the section line I-I' in Fig. 18;
Fig. 21 is another cross-sectional view along the section line I-I' in Fig. 18;
Fig. 22 is still another enlarged view of CC region in Fig. 5A;
Fig. 23 is a cross-sectional view along the section line J-J' in Fig. 22;
Fig. 24A is a structure diagram of yet another step structure according to some examples;
Fig. 24B is a structure diagram of still another step structure according to some examples;
Fig. 25 is still another enlarged view of CC region in Fig. 5A;
Fig. 26 is still another enlarged view of CC region in Fig. 5A;
Fig. 27 is a cross-sectional view along the section line K-K' in Fig. 26;
Figs. 28, 31, 32, 37, 40, 47, 49, 52 and 54 are flowcharts of a fabrication method of a three-dimensional memory according to some examples;
Figs. 29A-30, 33A-36, 38-39, 41A-46, 48, 50-51, 53, and 55-58 are step diagrams of a fabrication method of a three-dimensional memory according to some examples;
Figs. 59, 66, 72, 74, 77-78, and 80 are flowcharts of a fabrication method of another three-dimensional memory according to some examples;
Figs. 60-65, 67-71, 73, 75-76, 79 and 81-84 are step diagrams of a fabrication method of another three-dimensional memory according to some examples;
Fig. 85 is a structure diagram of another three-dimensional memory according to some examples;
Fig. 86 is a structure diagram of yet another three-dimensional memory according to some examples;
Fig. 87 is a structure diagram of a memory system according to some examples; and
Fig. 88 is a structure diagram of another memory system according to some examples.

### DETAILED DESCRIPTION

The technical solutions in some examples of the present disclosure will be described below clearly and completely in conjunction with accompanying drawings. However, it is obvious that the described examples are only a part of the examples of the present disclosure, rather than all examples thereof. All other examples obtained by those of ordinary skill in the art based on examples provided in the present disclosure fall within the scope of the present disclosure.

In the description of the present disclosure, it is to be understood that terms "center", "on", "under", "front", "back", "left", "right", "vertical", "horizontal", "top", "bottom", "inside", "outside" etc. refer to the orientation or position relationship which is based on what is shown in figures, which are only for the purpose of facilitating describing the present disclosure and simplifying description, rather than indicating or implying that the mentioned devices or elements must have certain orientation, must be constructed and operated in certain orientation, and therefore these terms cannot be constructed as limiting the present disclosure.

Unless otherwise stated in context, the term "include" will be interpreted in an open and containing sense, namely "contain but not limited to" throughout the description and claims. In the description of the specification, the terms "one example", "some examples", "example implementation", "as an example" or "some examples" are intended to mean that particular features, structures, materials or characteristics related to the examples or implementations are included in at least one example or implementation of the present disclosure. The illustrative representation of the above terms does not necessarily refer to the same example or implementation. Furthermore, the particular features, structures, materials or characteristics may be included in any suitable way in any one or more examples or implementations.

Hereinbelow, terms such as "first", "second" etc. are only used for description rather than being interpreted as indicating or implying relative importance or implicitly indicating the number of the indicated technical features. Therefore, a feature defined by "first" or "second" may include explicitly or implicitly one or more instances of the feature. In the description of the examples of the present disclosure, "a plurality of" means two or more unless otherwise specified.

While describing some examples, expressions such as "couple" and "connect" as well as their extensions may be used. For example, the term "connect" may be used while describing some examples to indicate that two or more components have direct physical contact or electrical contact. As another example, the term "couple" may be used while describing some examples to indicate that two or more components have direct physical contact or electrical contact. However, the term "couple" may also indicate there is no direct contact between two or more components, but they still cooperate or interact with each other. Examples disclosed herein are not necessarily limited to the contents provided herein.

"At least one of A, B and C" and "at least one of A, B or C" have the same meaning and both include the following combinations of A, B and C: only A; only B; only C; a combination of A and B; a combination of A and C; a combination of B and C; and a combination of A, B and C.

"A and/or B" includes the following three combinations: only A, only B and a combination of A and B.

As used herein, "about", "generally" or "approximately" include a stated value and an average value within the acceptable deviation range of a certain value, wherein the acceptable deviation range is determined by those of ordinary skill in the art considering the measurements under discussion and errors, namely limitations of the measurement system, related to measurements of a certain quantity.

In the present disclosure, the meaning of "on", "over" and "above" should be interpreted in the broadest manner such that "on" not only means "directly on" something but also includes the meaning of "on" something with an intermediate feature or a layer therebetween, and that "over" or "above" not only include the meaning of "over" or "above" something, but also include the meaning of "over" or "above" something with no intermediate feature or layer therebetween (i.e., directly on something).

Example implementations are described herein with reference to cross-sectional views and/or plan views as ideal illustrative drawings. In the drawings, thicknesses of layers and regions are exaggerated for clear illustration. Therefore, it is possible to envision shape variations with respect to drawings due to manufacturing techniques and/or tolerances, for example. Accordingly, example implementations should not be interpreted as limiting to the shapes of regions shown herein, but including shape deviations caused by manufacturing, for example. For example, an etched region shown as rectangular may have curved features. Therefore, regions shown in drawings are illustrative essentially, and their shapes are not intended to show practical shapes of regions of an apparatus and not intended to limit the scope of example implementations.

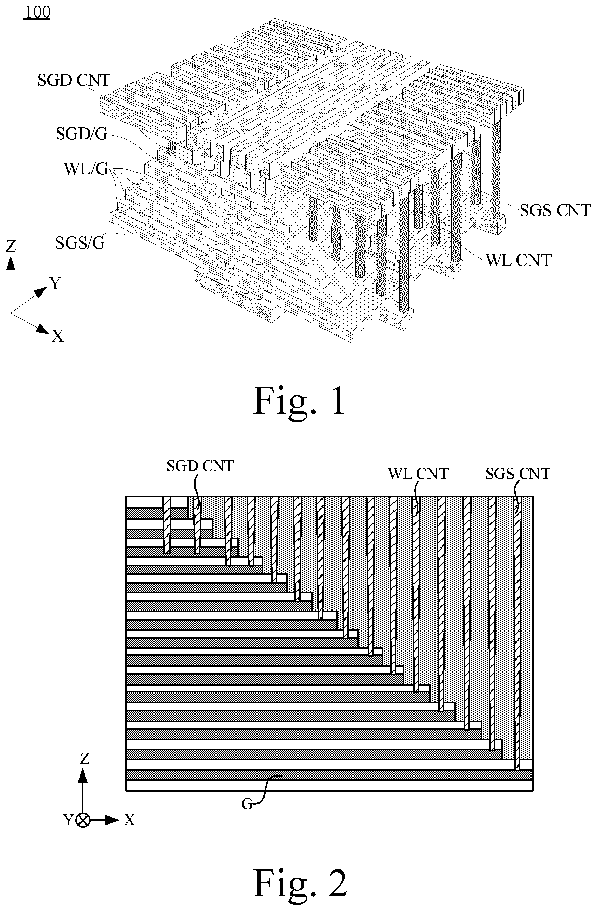

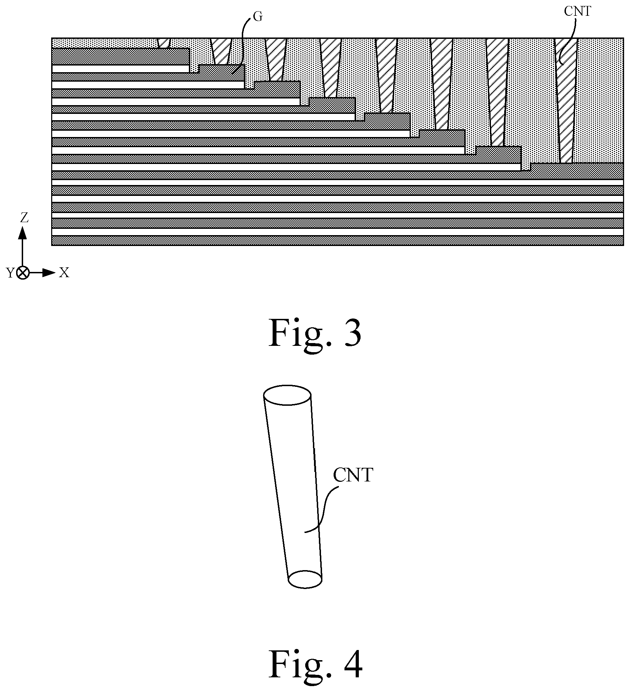

Referring to Figs. 1-3, Fig. 1 is a perspective structure diagram of a three-dimensional memory 100, and Figs. 2 and 3 are two structure diagrams of parts of contact posts and steps in the related art.

In some examples, as shown in Fig. 1, the three-dimensional memory 100 includes a stack structure having a step structure and including a plurality of gate layers G and dielectric layers disposed alternately (not shown in Fig. 1). Both the gate layers G and the dielectric layers extend in a first direction X. In a third direction Z, at least one gate layer G at the bottom of the plurality of gate layers G is configured as a source end select gate SGS, at least one gate layer G which is uppermost among the plurality of gate layers G is configured as a drain end select gate SGD, and the gate layer G between the source end select gate SGS and the drain end select gate SGD is configured as a plurality of word lines WL.

In order to supply electrical signals to the source end select gate SGS, the drain end select gate SGD and the word lines WL, the three-dimensional memory 100 further includes a plurality of contact posts CNT. Among the plurality of contact posts CNT, the contact post CNT electrically connected with the drain end select gate SGD is configured as a drain end select gate contact post SGD CNT, the contact post CNT electrically connected with the source end select gate SGS is configured as a source end select gate contact post SGS CNT, and the contact post CNT electrically connected with the word line WL is configured as a word line contact post WL CNT.

Referring to Fig. 2, as the integration level increases, the number of stacked layers of gate layers G and dielectric layers in the three-dimensional memory increases gradually, and the difference between depths of different contact posts CNT in the third direction Z increase more and more. Therefore, in the process of forming the plurality of contact posts CNT, steps in higher layers are prone to be penetrated through by the contact holes where contact posts CNT are located, thereby resulting in shorting among different gate layers G after forming the plurality of contact posts CNT, and causing failure of the three-dimensional memory.

In view of this problem, referring to Fig. 3, in the related art, the problem that the gate layer G are prone to be penetrated through during fabrication of the contact posts CNT is improved by increasing the thickness of the gate layer G at the step. However, in order to prevent contact holes from penetrating through the gate layer G at the step, the gate layer G at the step needs to have a large thickness, resulting in a high forming difficulty.

Therefore, while increasing thickness of the gate layer G at the step as more as possible, in the related art, etching rate is reduced to prevent the contact hole from penetrating through the gate layer G at the step. However, as shown in Fig. 4, since the etching rate is slow, and the etching directionality is poor, the linearity of the contact hole obtained by etching is poor, and the linearity of the contact post CNT is also poor. Severely, in the process of etching the contact hole, it is likely to etch the dummy channel structures adjacent to the contact hole due to the poor etching directionality, resulting in the conductive material also filled in the dummy channel structure after forming the contact post, thereby shorting the plurality of gate layers and resulting a three-dimensional memory with poor performance.

In addition, when the thickness of the gate layer G at the step is large, in the process of gate layer replacement by using a gate line slit, the conductive material might remain in the gate line slits, thereby shorting the plurality of gate layers and causing failure of the three-dimensional memory after the gate layer replacement.

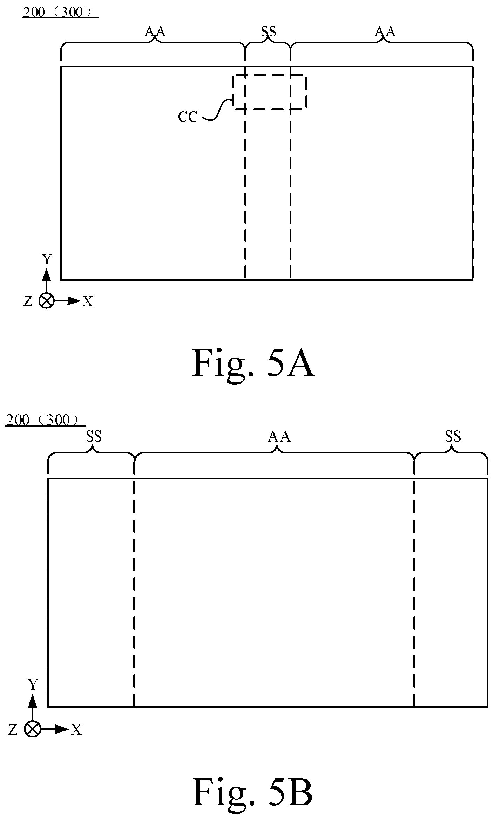

In order to address at least one problem described above, referring to Figs. 5A-8, some examples of the present disclosure provide a three-dimensional memory 200.

As shown in Figs. 5A and 5B, in a first direction X, the three-dimensional memory 200 includes a core array region AA and a step region SS. As shown in Fig. 5A, the three-dimensional memory 200 may include two core array regions AA and one step region SS, the step region SS located between the two core array regions AA. Alternatively, as shown in Fig. 5B, the three-dimensional memory 200 may include two step regions SS and one core array region AA, the core array region AA located between the two step regions SS.

It is appreciated that the manner of distribution of core array regions AA and step regions SS in the three-dimensional memory 200 provided in some examples of the present disclosure is not limited thereto.

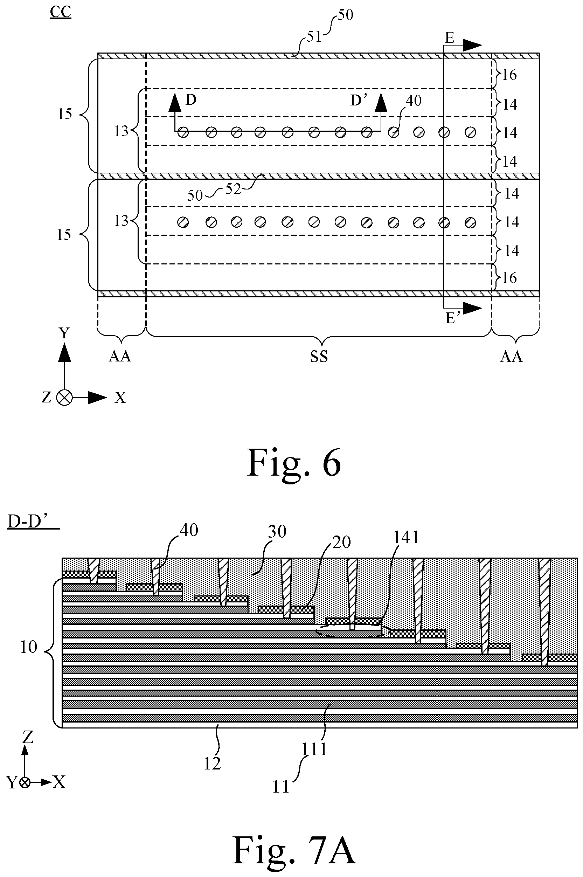

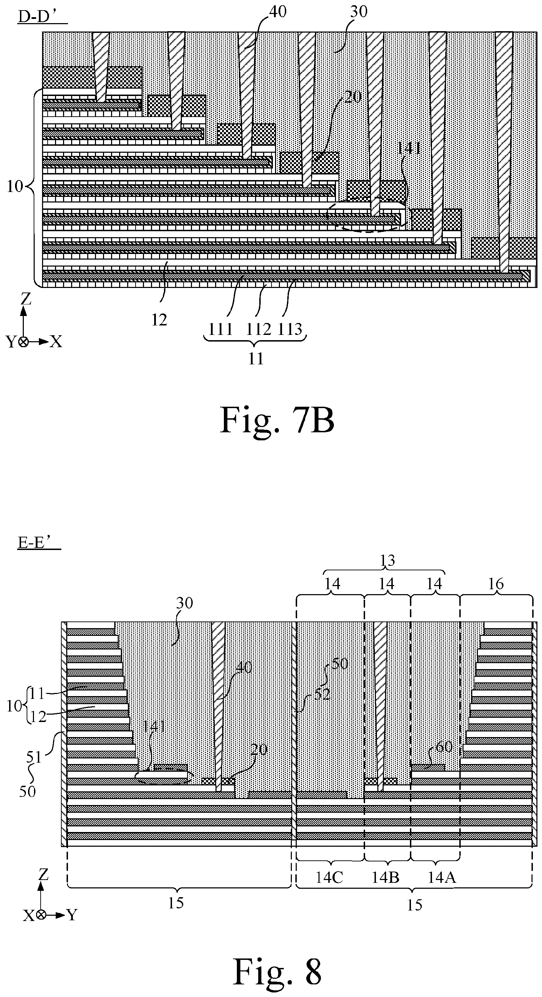

Fig. 6 is an enlarged view of CC region in Fig. 5A. Figs. 7A and 7B are cross-sectional views along section line D-D' in Fig. 6, and Fig. 8 is a cross-sectional view along section line E-E' in Fig. 6.

Referring to Figs. 6-8, the three-dimensional memory 200 includes a stack structure 10, a plurality of first stops 20 disposed in the first direction X, a protection layer 30 and a plurality of contact posts 40.

The stack structure 10 includes gate layers 11 and dielectric layers 12 disposed alternately.

In some examples, referring to Fig. 7A, the gate layer 11 may be a single-layered structure. Then, the gate layer 11 includes a conductive layer 111. The material for the conductive layer 111 includes, but not limited to tungsten, cobalt, copper, aluminum, or doped crystalline silicon, doped silicon and/or silicide.

In some examples, referring to Fig. 7B, the gate layer 11 may be a multi-layered composite structure. At this time, the gate layer 11 may include a high dielectric constant layer 112, a metal compound layer 113 and a conductive layer 111 formed sequentially. The material for the high dielectric constant layer 112 may include, for example, aluminum oxide (Al₂O₃), the material for the metal compound 113 may include, for example, tantalum nitride or titanium nitride.

Illustratively, the dielectric layer 12 may be made of insulating material, including, but not limited to silicon oxide, silicon nitride, silicon oxynitride or combinations thereof.

It is to be noted that in the stack structure 10, the thicknesses of the plurality of gate layers 11 may be approximately the same or different. The thicknesses of the plurality of dielectric layers 12 may be approximately the same or different. It is possible to select the thicknesses of the plurality of gate layers 11 and the plurality of dielectric layers 12 according to practical demands. Furthermore, the number of stacked layers in the stack structure 10 determines the number of memory cells. The more the number of stacked layers in the stack structure 10 is, the higher the integration level is, that is, the more the number of memory cells is. In an example, the number of stacked layers and the height of the stack structure 10 may be designed based on actual storage demands, which is not limited in the present disclosure.

The stack structure 10 includes a step structure 13 including a plurality of staircase structures 14 disposed in the first direction X and having different heights in a second direction Y. The staircase structure 14 includes a plurality of steps 141. The first direction X is perpendicular to the second direction Y.

It is appreciated that when the step structure 13 includes the staircase structures 14 disposed in the first direction X and having different heights in the second direction Y, two adjacent staircase structures 14 in the plurality of staircase structures 14 included in the step structure 13 have different heights, while two staircase structures 14 disposed at intervals might have the same heights.

In some examples, referring to Figs. 6 and 8, the step structure 13 may include three staircase structures 14 disposed in the second direction Y and having heights different from each other.

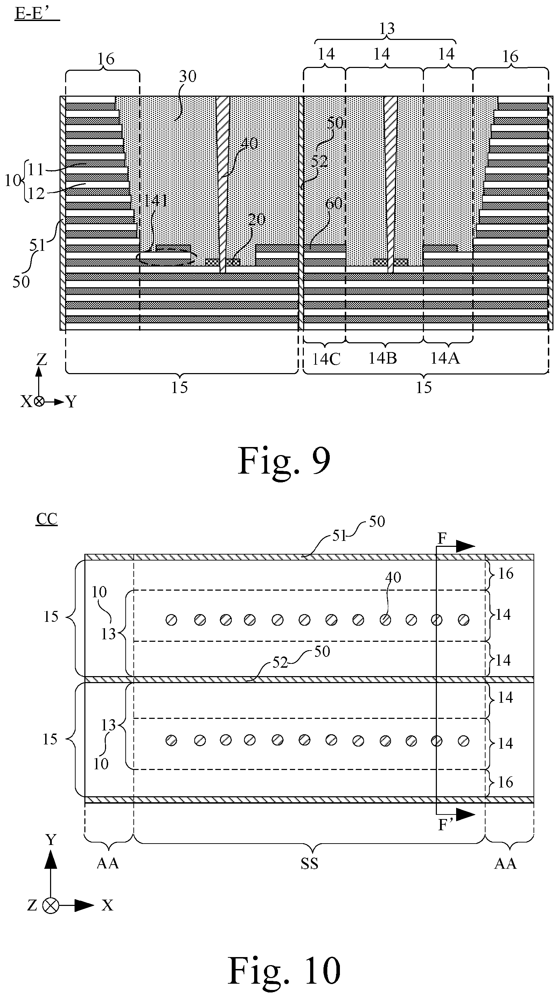

In some other examples, referring to Figs. 6 and 9, the step structure 13 may include three staircase structures 14 disposed in the second direction Y, with the two staircase structures 14 on two sides having heights different from that of the staircase structure 14 in the middle, while having the same height with each other.

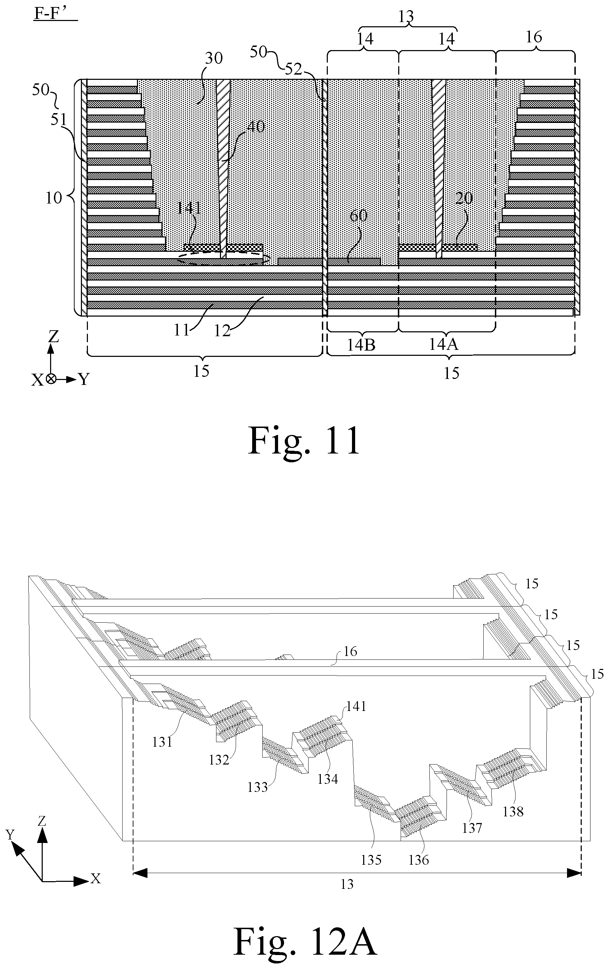

In yet some examples, referring to Figs. 10 and 11, the step structure 13 may include two staircase structures 14 disposed in the second direction Y and having heights different from each other.

It is to be note that the number of the staircase structures 14 in the present disclosure is not limited thereto.

A plurality of first stops 20 are disposed in the first direction X and located on the plurality of steps 141 of at least one staircase structure 14, with each first stop 20 located on one step 141.

As shown in Figs. 8, 9 and 11, the plurality of first stops may be only located on the plurality of steps 141 of one staircase structure 14. It is also possible that the plurality of first stops 20 are located on the plurality of steps 141 of the plurality of staircase structures 14.

As shown in Fig. 8, the step 141 may include one gate layer 11 and one dielectric layer 12. Alternatively, the step 141 may include a plurality of gate layers 11 and a plurality of dielectric layers 12. This is not limited in the present disclosure.

As shown in Fig. 8, the protection layer 30 covers the step structure 13 and the first stops 20, and at least a part of the protection layer 30 is located between the first stop 20 and the step 141 adjacent to the first stop 20.

It is appreciated that "the step 141 adjacent to the first stop 20" may not only include the step 141 adjacent to the first stop 20 in the first direction X as shown in Fig. 7A, but also include the step 141 adjacent to the first stop 20 in the second direction Y as shown in Fig. 8.

Illustratively, the protection layer 30 may be made of silicon oxide, including, but not limited to tetraethoxysilane (TEOS), siloxane, silsesquioxane etc. Illustratively, the protection layer 30 may be formed by chemical vapor deposition (CVD) process, spin coating process etc.

There is at least a part of the protection layer 30 between the first stop 20 and the step 141 adjacent to the first stop 20. Therefore, it is possible to isolate the sacrificial layer and the first stop 20 with the protection layer 30 in the process of forming the gate layer 11, thus preventing the first stop from also being replaced at the same time as the sacrificial layer is replaced with the gate layer, which would otherwise cause the contact post to penetrate through the replaced first stop and be electrically connected with the plurality of gate layers, thereby causing failure of the three-dimensional memory.

The contact post of the plurality of contact posts 40 extends through the protection layer 30 and the first stop 20 and is connected with the gate layer 11 in the step corresponding to the first stop 20.

Illustratively, the contact posts 40 may be made of conductive material including, but not limited to metals such as tungsten, copper, aluminum etc., metal silicides, metal nitrides and/or doped polysilicon.

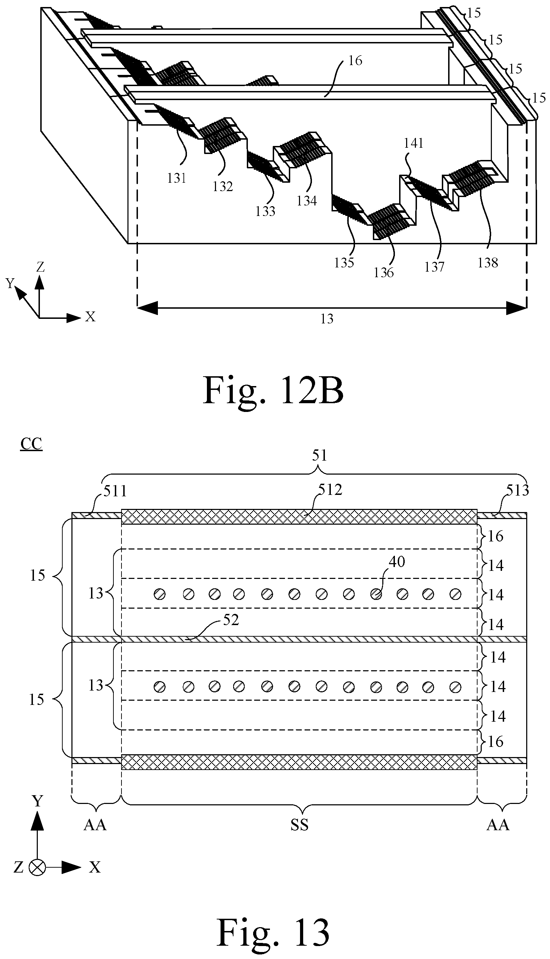

It is appreciated that the above-described step structure 13 is located in the step region SS. When the step region SS is located between two core array regions AA, the topography of the step structure 13 may be as shown in Figs. 12A and 12B. That is, in the first direction X, the step structure 13 may include at least one step group in which a plurality of steps 141 have heights increasing or decreasing gradually.

Illustratively, as shown in Figs. 12A and 12B, in the first direction X, the step structure 13 may include 8 step groups, which are a first step group 131, a second step group 132, a third step group 133, a fourth step group 134, a fifth step group 135, a sixth step group 136, a seventh step group 137 and an eighth step group 138 sequentially. In the first direction X, the plurality of steps 141 in the first step group 131, the third step group 133, the fifth step group 135 and the seventh step group 137 have heights decreasing gradually. In the first direction X, the plurality of steps 141 in the second step group 132, the fourth step group 134, the sixth step group 136 and the eighth step group 138 have heights increasing gradually. Of course, forms of the step structures 13 in the present disclosure are not limited thereto.

In the three-dimensional memory 200 provided in some examples of the present disclosure, a plurality of first stops 20 are disposed on at least one staircase structure 14 in the step structure 13. Therefore, when forming the contact hole 41 where the contact post 40 is located, it is possible to remove a part of the protection layer on the first stop 20 with an etching process such as wet etching to expose a part of the first stop 20, then remove the exposed part of the first stop 20 and the dielectric layer 12 between the first stop 20 and the underlying gate layer 11 with the etching process to expose a part of the gate layer 11.

In the first etching process, due to the presence of the first stop 20, contact holes 41 with different depths corresponding to the steps 141 with different heights may stop at the respective first stops 20 on the steps 141. In the second etching process, since distances between the respective first stops 20 and the gate layers 11 of the steps 141 where the first stops 20 are located are approximately the same, then in the second etching process, while etching for the same time, contact holes 41 with different depths corresponding to the steps 141 with different heights may stop at the respective gate layers 11 on the steps 141.

Thus, while forming the contact post 40 in the contact hole 41, the contact post 40 may contact the gate layer 11 of the corresponding step 141, facilitating avoiding shorting among the plurality of gate layers due to the contact post extending through the gate layer resulting from the increase of the number of layers in the stack structure, thereby improving the electrical performance and yield of the three-dimensional memory.

At the same time, since the first stop 20 is provided, while forming the contact hole where the contact post is located with an etching process, the etching rate may be fast, thereby resulting in a better linearity for the contact hole 41 (or contact post 40), which in turn makes the dielectric layer in dummy channel structure adjacent to the contact post 40 is not prone to be etched, thereby improving the yield of the three-dimensional memory 200.

Referring to Figs. 6-12B, in some examples, the three-dimensional memory 200 further includes isolation structures 50. The isolation structures 50 extend in the first direction X and through the stack structure 10. The isolation structures 50 divide the stack structure 10 into a plurality of memory blocks 15. Each memory block 15 includes a step structure 13. The staircase structures 14 where the first stops 20 are located are disposed at intervals with the isolation structures 50.

By "the staircase structures 14 where the first stops 20 are located are disposed at intervals with the isolation structures 50", it means a plurality of first stops 20 are disposed at intervals with the isolation structures 50.

In some examples of the present disclosure, the stack structure 10 is divided into the plurality of memory blocks 15 with the isolation structures 50, which allows further improving the memory density of the three-dimensional memory 200. Meanwhile, the staircase structures 14 where the first stops 20 are located are disposed at intervals with the isolation structures 50, which may also avoid the case in which the first stop 20 is replaced in the subsequent process of forming the gate layer 11 by performing gate replacement by using the slit where the isolation structure 50 is located, which may cause the contact post to penetrate through the replaced first stop and be electrically connected with the plurality of gate layers, thus resulting in failure of the three-dimensional memory.

It is to be noted that when the isolation structures 50 divide the stack structure 10 into the plurality of memory blocks 15, the isolation structures 50 also divide the gate layer 11 into a plurality of gate lines such as source end select gates or drain end select gates or word lines. Each memory block 15 includes a plurality of gate lines disposed at intervals in the third direction Z.

Illustratively, the first direction X may be an extending direction of the gate lines. The second direction Y may be an extending direction of bit lines. The third direction Z may be a stacking direction of the stack structure 10.

In some examples, referring to Figs. 6, 8 and 9, in the second direction Y, the memory block 15 includes a first staircase structure 14A, a second staircase structure 14B and a third staircase structure 14C, with the first stop 20 disposed on the plurality of steps 141 of the second staircase structure 14B.

Thus, the second staircase structure 14B has a height difference in the third direction Z with both the first staircase structure 14A and the third staircase structure 14C, and is disposed at intervals with the isolation structure 50 (that is, the first staircase structure 14A and the third staircase structure 14C are between the second staircase structure 14B and the isolation structure 50), which facilitates subsequently etching the step and forming the first stop 20, such that a spacing exists between the first stop 20 and adjacent step 141, thus preventing the first stop from being replaced.

In some other examples, referring to Fig. 11, in the second direction Y, the memory block 15 includes a first staircase structure 14A and a second staircase structure 14B, with the first staircase structure 14A disposed at intervals with the isolation structure 50, and the first stops 20 are disposed on the plurality of steps 141 of the first staircase structure 14A.

Thus, the first staircase structure 14A has a height difference in the third direction Z with the second staircase structure 14B and is disposed at intervals with the isolation structure 50, which facilitates subsequently etching the step and forming the first stop 20, such that a spacing exists between the first stop 20 and side face of adjacent step 141, thus preventing the first stop 20 from being replaced.

In some examples, referring to Figs. 6-11, each memory block 15 further includes a sidewall 16 serving as a bridge structure for connecting two core array regions AA. In some examples, the gate layers included in the staircase structure are connected to gate layers of at least one of the two core array regions AA by the bridge structure. The isolation structures 50 include a first isolation structure 51 and a second isolation structure 52. In the second direction Y, the first isolation structure 51 is located between two adjacent sidewalls 16, and the second isolation structure 52 is located between two adjacent step structures 13. The sidewall 16 is configured to enhance the structure stability of the three-dimensional memory 200.

In some examples, as shown in Figs. 6 and 10, the first isolation structure 51 may be an integral structure. That is, when fabricating the first isolation structure 51, it is possible to obtain an slit where the first isolation structure 51 is located by etching with one etching process, and form the first isolation structure 51 in the slit.

In some other examples, as shown in Fig. 13, the first isolation structure 51 may include a first isolation sub portion 511, a second isolation sub portion 512 and a third isolation sub portion 513 connected sequentially in the first direction X. The second isolation sub portion 512 has a size in the second direction Y larger than that of the first isolation sub portion 511 and larger than that of the third isolation sub portion 513.

Illustratively, the first isolation sub portion 511 has a size in the second direction Y approximately the same as that of the third isolation sub portion 513.

Illustratively, the first isolation sub portion 511 and the third isolation sub portion 513 are located in the core array region AA, the second isolation sub portion 512 is located in the step region SS and contacts the sidewall 16.

Illustratively, the second isolation sub portion 512 may be fabricated simultaneously with the dummy channel structures and channel structures. The first isolation sub portion 511 and the third isolation sub portion 513 may be fabricated after completing the fabrication of the channel structures. Based on this, the material for the second isolation sub portion 512 may be the same as the material for the dummy channel structures or channel structures.

In some examples of the present disclosure, by providing the second isolation sub portion 512, it is possible on one hand to separate two adjacent memory blocks 15, and on the other hand to support the stack structure 10, preventing the stack structure 10 from collapsing.

In some examples, referring to Figs. 6, 10 and 13, in the second direction Y, the step structures 13 in the two memory blocks 15 adj acent to the second isolation structure 52 are disposed symmetrically.

It is appreciated that, by "the step structures 13 in the two memory blocks 15 are disposed symmetrically", it means that the number of staircase structures 14 included in the step structures 13 of the two memory blocks 15 is the same, and the two staircase structures 14 in the two step structures 13 that have equal distance from the second isolation structure 52 have the same height.

In some examples, referring to Figs. 8 and 11, in the second direction Y and along a direction from the first isolation structure 51 toward the second isolation structure 52, the heights of the plurality of staircase structures 14 in the memory block 15 decrease gradually.

In some other examples, referring to Fig. 9, in the second direction Y and along a direction from the first isolation structure 51 toward the second isolation structure 52, the heights of the plurality of staircase structures 14 in the memory block 15 decrease first and then increase.

In some examples, referring to Figs. 8 and 9, in the second direction Y, the two staircase structures 14 adjacent to the two sides of the second isolation structure 52 have the same height.

In some examples, referring to Fig. 11, the three-dimensional memory 200 further includes a plurality of second stops 60 disposed in the first direction X. The plurality of second stops 60 are located on the plurality of steps 141 of other staircase structures 14 among the plurality of staircase structures 14 other than the staircase structures 14 on which the first stops 20 are disposed.

The protection layer 30 further covers the second stop 60 and at least a part of the protection layer 30 is located between the second stop 60 and the step 141 adjacent to the second stop 60.

Illustratively, referring to Figs. 8 and 9, when the first stops 20 are located on the plurality of steps 141 of the second staircase structure 14B, the second stops 60 may be located on the plurality of steps 141 of the first staircase structure 14A and the third staircase structure 14C.

Illustratively, referring to Fig. 11, when the first stops 20 are located on the plurality of steps 141 of the first staircase structure 14A, the second stops 60 may be located on the plurality of steps 141 of the second staircase structure 14B.

In some examples, the materials for the first stops 20 and the second stops 60 are the same. Illustratively, when the materials for the first stops 20 and the second stops 60 are the same, the material for the first stops 20 and the second stops 60 may include for example carbon doped silicon nitride. Alternatively, in an example, when the materials for the first stops 20 and the second stops 60 are the same, the material for the first stops 20 and the second stops 60 may be for example silicon nitride.

Illustratively, the material for the first stops 20 may be silicon nitride.

As such, the material for the first stops 20 and the material for the gate layers 11 are different, and the etch selection ratio for the first stops 20 and that for the gate layers 11 are different. The first stops 20 are prone to be etched through when forming the contact holes with etch process. Therefore, when fabricating the contact holes 411 where the contact posts are located, it is possible to first make the plurality of contact holes 41 corresponding to the steps 141 with different heights to stop at the first stops 20, with the distances between bottoms of respective contact holes 41 and the steps 141 approximately the same; and then etch the first stops 20 exposed by the plurality of contact holes 41 and etch the dielectric layer 12 under the first stops 20 with the etching process, such that the contact holes 41 expose the gate layers 11 in their corresponding steps 141. Therefore, the problem that the contact hole penetrates through the steps in higher layers, and shorting occurs between gate layers in adjacent steps of the higher layers after filling conductive material in the contact holes to form the contact posts is avoided, and the electrical performance and yield of three-dimensional memory are improved.

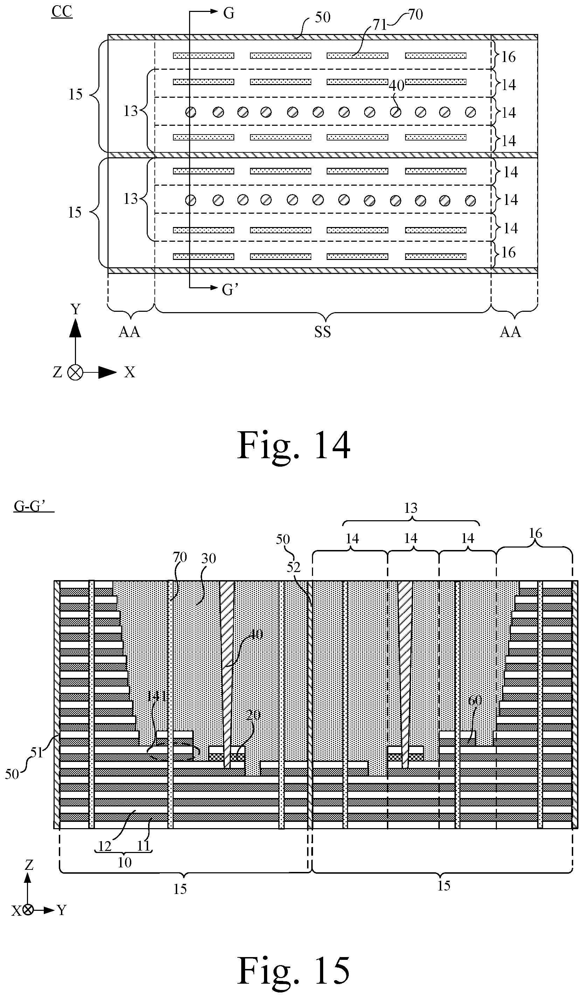

In some examples, as shown in Figs. 14 and 15, the three-dimensional memory 200 further includes a plurality of gate line isolation structures 70 extending in the first direction X and located between two adjacent isolation structures 50. The gate line isolation structure 70 extends through the second stop 60 and the stack structure 10 therebelow. In the first direction X, each gate line isolation structure 70 includes a plurality of sub isolation structures 71 separated from each other. The material for the second stop 60 is the same as that for the gate layer 11.

By "the gate line isolation structure 70 extends through the second stop 60 and the stack structure 10 therebelow", it means that the slit where the gate line isolation structure 70 is located extends through the second stop 60 and the stack structure 10 therebelow. Therefore, it is possible to perform gate replacement by using the slit where the gate line isolation structure 70 is located, thereby replacing the sacrificial layer in the initial stack structure 101 with the gate layer 11. At the same time, the material for the second stop is replaced with the material for the gate layer by using the slit where the gate line isolation structure 70 is located.

By providing the gate line isolation structure 70, it may also release stress for the three-dimensional memory 200.

In some examples, the second stop 60 may be a single-layered structure, which is the same as the gate layer 11. Then, the second stop 60 also includes a conductive layer 111. The material for the conductive layer 111 includes, but not limited to tungsten, cobalt, copper, aluminum, or doped crystalline silicon, doped silicon and/or silicide.

In some examples, the second stops 60 may be composite multiple-layered structure, which is the same as the gate layer 11. Then, the second stop 60 may include a high dielectric constant layer 112, a metal compound layer 113 and a conductive layer 111, wherein the high dielectric constant layer 112 wraps the conductive layer 111 and the metal compound layer 113 is between the high dielectric constant layer 112 and the conductive layer 111. The material for the high dielectric constant layer 112 may include for example aluminum oxide (Al₂O₃), and the material for the metal compound 113 may include for example tantalum nitride or titanium nitride.

In some examples, referring to Figs. 8, 9, 11 and 15, in the third direction Z, the thickness of the first stop 20 is the same as that of the gate layer 11 of the previous step 141. The previous step 141 is adjacent to and higher than the step 141 corresponding to the first stop 20.

Then, it is possible to fabricate the first stop 20 with the sacrificial layer for fabricating the gate layer 11 of the previous step 141, thus eliminating the need for separately depositing the first stop 20, which in turn simplifies the fabrication process of the three-dimensional memory 200 and reduces the manufacturing costs of the three-dimensional memory 200.

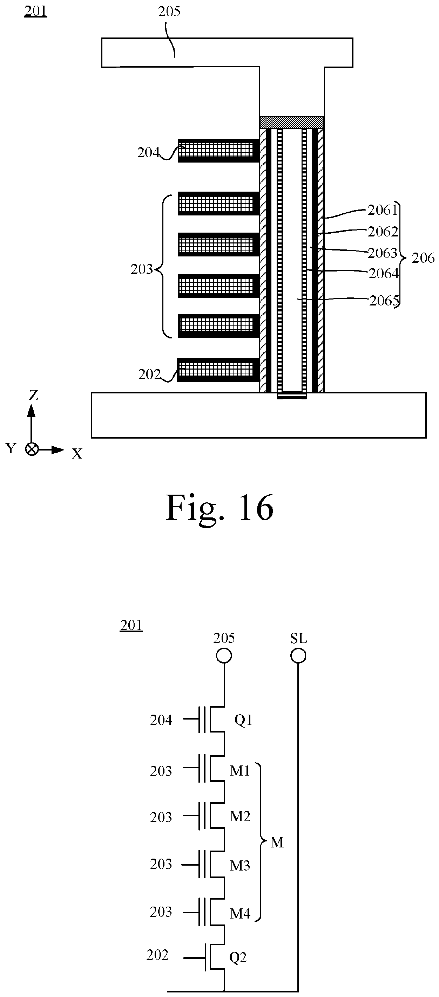

In some examples, the three-dimensional memory 200 includes a plurality of memory cell strings 201 arranged in an array in the core array region AA. Illustratively, referring to Fig. 16, in the third direction Z, the memory cell string 201 includes a ground select line layer 202 (bottom select gate), a word line layer 203, a string select line layer 204 (top select gate) and a bit line 205 arranged sequentially. The memory cell string 201 further includes an array of channel structures 206 extending through the string select line layer 204, the word line layer 203 and the ground select line layer 202 in the third direction Z. The channel structure 206 connects the string select line layer 204, the word line layer 203 and the ground select line layer 202 in series to form the memory cell string 201.

In some examples, referring to Fig. 16, the channel structure 206 may include a blocking layer 2061, a storage layer 2062, a tunneling layer 2063, a channel layer 2064 and a filling layer 2065 disposed sequentially.

Illustratively, the blocking layer 2061 may include one layer, for example, a silicon dioxide (SiO₂) layer. The blocking layer 2061 may also include a plurality of layers, for example, a stack of silicon dioxide and aluminum oxide O(Al₂O₃). The storage layer 2062 may include one layer, such as a silicon nitride (SiN) layer. The storage layer 2062 may also include a plurality of layers, such as a stack of silicon nitride, silicon oxynitride (SiON) and silicon nitride. The tunneling layer 2063 may include a plurality of layers, such as a stack of silicon monoxide (SiO), silicon oxynitride and silicon oxide. The material for the channel layer 2064 includes a semiconductor material such as polysilicon and/or single crystalline silicon. The material for the filling layer 2065 may include an insulating material such as silicon dioxide.

Referring to Fig. 17, a first end of the memory cell string 201 is connected to a bit line 205 and a second end is connected to a source line SL. The memory cell string 201 includes a plurality of transistors connected in series between the first end and the second end, including at least one top select transistor Q1, at least one storage transistor M and at least one bottom select transistor Q2. Illustratively, Fig. 17 shows one top select transistor Q1, four storage transistors M and one bottom select transistor Q2. The four storage transistors M are M1, M2, M3 and M4 respectively.

Referring to Figs. 5A, 5B, 18-21, some other examples of the present disclosure provide another three-dimensional memory 300.

Similarly, as shown in Figs. 5A and 5B, in the first direction X, the three-dimensional memory 300 includes a core array region AA and a step region SS. As shown in Fig. 5A, the three-dimensional memory 300 may include two core array regions AA and one step region SS, the step region SS located between the two core array regions AA. Alternatively, as shown in Fig. 5B, the three-dimensional memory 300 may include two step regions SS and one core array region AA, the core array region AA located between the two step regions SS.

It is appreciated that the manner of distribution of the core array regions AA and the step regions SS in the three-dimensional memory 300 provided in some examples of the present disclosure is not limited thereto.

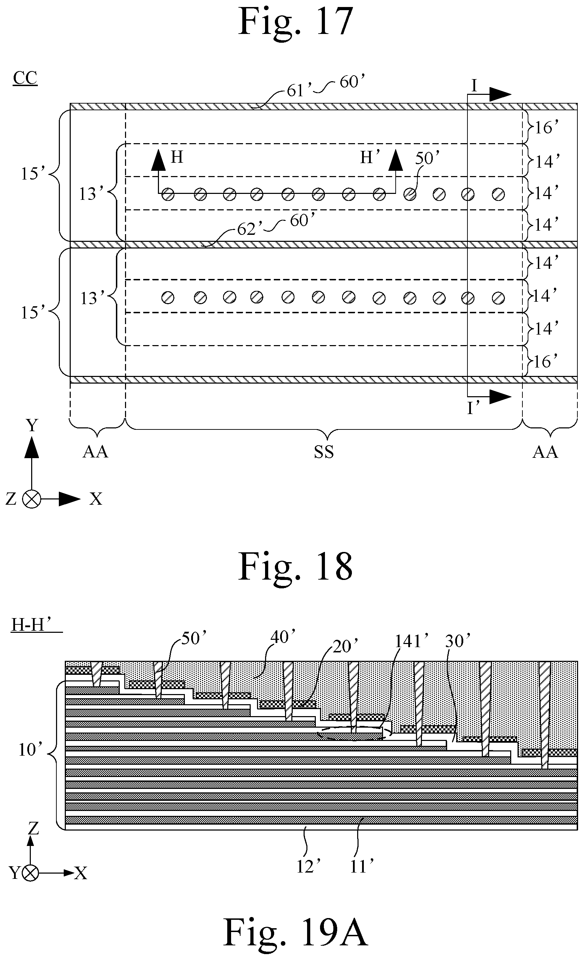

Referring to Fig. 18, the three-dimensional memory 300 includes a stack structure 10', a plurality of first stops 20' disposed in the first direction X, a separating layer 30', a protection layer 40' and a plurality of contact posts 50'.

The stack structure 10' includes gate layers 11' and dielectric layers 12' disposed alternately.

In some examples, as shown Fig. 19A, the gate layer 11' may be a single-layered structure. At this time, the gate layer 11' includes a conductive layer 111'. The material for the conductive layer 111' includes, but not limited to tungsten, cobalt, copper, aluminum, or doped crystalline silicon, doped silicon and/or silicide.

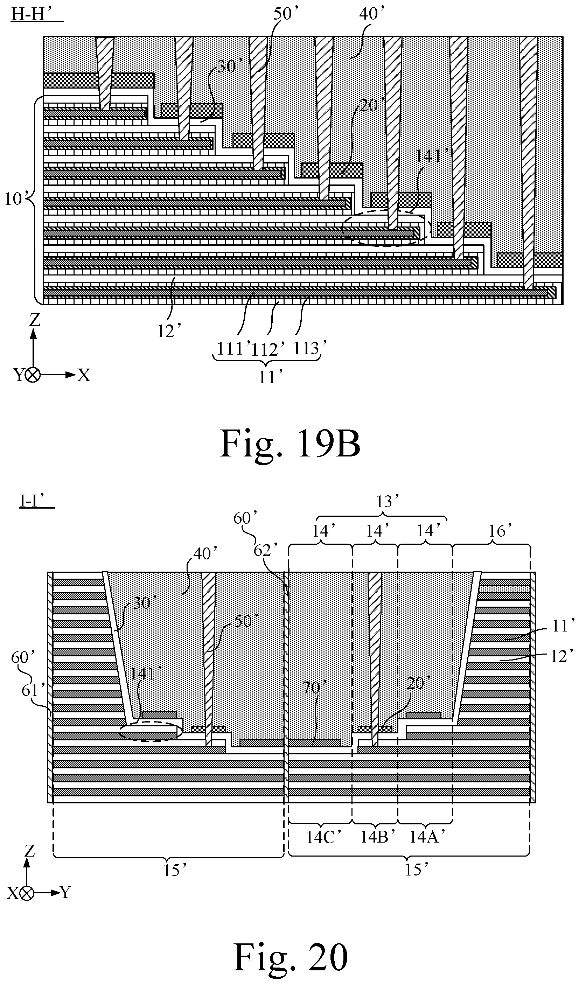

In some other examples, as shown Fig. 19B, the gate layer 11' may be a multi-layered composite structure. At this time, the gate layer 11' may include a high dielectric constant layer 112', a metal compound layer 113' and a conductive layer 111' formed sequentially. The material for the high dielectric constant layer 112' may include for example aluminum oxide (Al₂O₃), and the material for the metal compound 113' may include for example tantalum nitride or titanium nitride.

Illustratively, the dielectric layer 12' may be made of insulating material, including, but not limited to silicon oxide, silicon nitride, silicon oxynitride or combinations thereof.

It is to be noted that in the stack structure 10', the thicknesses of the plurality of gate layers 11' may be approximately the same or different. The thicknesses of the plurality of dielectric layers 12' may be approximately the same or different. It is possible to select the thicknesses of the plurality of gate layers 11' and the plurality of dielectric layers 12' according to practical demands. Furthermore, the number of stacked layers in the stack structure 10' determines the number of memory cells. The more the number of stacked layers in the stack structure 10' is, the higher the integration level is, that is, the more the number of memory cells is. In an example, the number of stacked layers and the height of the stack structure 10' may be designed based on actual storage demands, which is not limited in the present disclosure.

The stack structure 10' includes a step structure 13' including a plurality of staircase structures 14' disposed in the first direction X and having different heights in the second direction Y. The staircase structure 14' includes a plurality of steps 141'. The first direction X is perpendicular to the second direction Y.

It is appreciated that when the step structure 13' includes the staircase structures 14' disposed in the first direction X and having different heights in the second direction Y, as long as it is ensured that two adjacent staircase structures 14' in the plurality of staircase structures 14' included in the step structure 13 have different heights, the two staircase structures 14' disposed at intervals may have the same height.

Based on this, in some examples, referring to Fig. 20, the step structure 13' may include three staircase structures 14' disposed in the second direction Y and having different heights from each other.

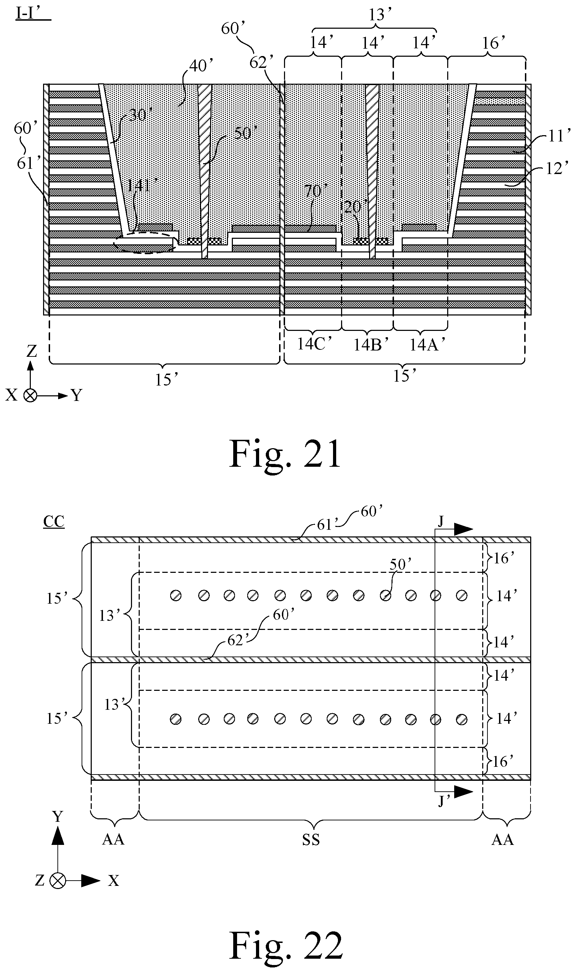

In some other examples, referring to Fig. 21, the step structure 13' may include three staircase structures 14' disposed in the second direction Y, with the two staircase structures 14' on two sides having heights different from that of the staircase structure in the middle, while having the same height with each other.

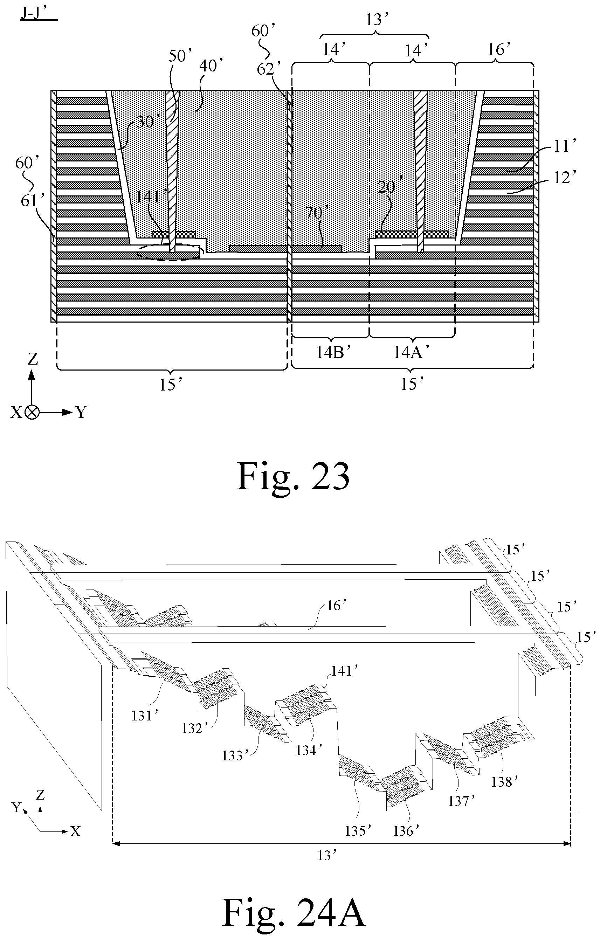

In yet some examples, referring to Figs. 22 and 23, the step structure 13' may include two staircase structures 14' disposed in the second direction Y and having heights different from each other.

It is to be note that the number of the staircase structures 14' in some examples of the present disclosure is not limited thereto.

A plurality of first stops 20' disposed in the first direction X are located on the plurality of the steps 141' of at least one staircase structure 14', with each first stop 20' on one step 141'.

As shown in Figs. 20, 21 and 23, the plurality of first stops 20' may be only located on the plurality of steps 141' of one staircase structure 14'. It is also possible that the plurality of first stops 20' are located on the plurality of steps 141' of the plurality of staircase structures 14'.

As shown in Figs. 20, 21 and 23, the step 141' may include one gate layer 11' and one dielectric layer 12'. Alternatively, the step 141' may include a plurality of gate layers 11' and a plurality of dielectric layers 12'. This is not limited in the present disclosure.

The separating layer 30' covers the step structure 13' and is located between the step structure 13' and the first stop 20'.

Illustratively, the separating layer 30' may be made of insulating material, including, but not limited to silicon oxide, silicon nitride, silicon oxynitride or combinations thereof.

It is appreciated that, as shown in Figs. 20, 21 and 23, by "the separating layer 30' is located between the step structure 13' and the plurality of first stop 20''', it means that in the third direction Z, the separating layer 30' is located between the first stop 20' and the step 141' of the step structure 13', and in the first direction Z and the second direction Y, the separating layer 30' is located between the first stop 20' and the step 141' adjacent to the first stop 20'.

In some examples of the present disclosure, by providing the separating layer 30', on one hand, it is possible to protect the step structure 13' with the separating layer 30' and in turn protect the stack structure 10'. On the other hand, it is possible to separate the gate layer 11' in the step structure 13' and the first stop 20' to avoid the case in which when forming the gate layer 11' of the step structure 13', the first stop 20' and the sacrificial layer is connected and the first stop 20' is also replaced, and also avoid the case in which the gate layer 11' and the first stop 20' are electrically connected, thereby resulting in failure of the three-dimensional memory 300.

The protection layer 40' covers the separating layer 30' and the first stop 20'.

Illustratively, the protection layer 40' may be made of silicon oxide, including, but not limited to tetraethoxysilane (TEOS), siloxane, silsesquioxane etc. Illustratively, the protection layer 40' may be formed by chemical vapor deposition (CVD) process, spin coating process etc.

In some examples, referring to Figs. 19A and 20, when the protection layer 40' covers the separating layer 30' and the first stop 20', in the first direction X, at least a part of the protection layer 40' is located between the side face of the first stop 20' and the separating layer 30', and in the second direction Y, at least a part of the protection layer 40' is located between the side face of the first stop 20' and the separating layer 30'.

Thus, it facilitates separating the plurality of first stops 20' from each other and avoiding electrical connection among the plurality of first stops 20'.

The contact post 50' of the plurality of contact posts 50' extends through the protection layer 40', the first stop 20' and the separating layer 30' and is connected with the gate layer 11' in the step 141' corresponding to the first stop 20'.

Illustratively, the contact post 50' may be made of conductive material including, but not limited to metals such as tungsten, copper, aluminum etc., metal silicides, metal nitrides and/or doped polysilicon.

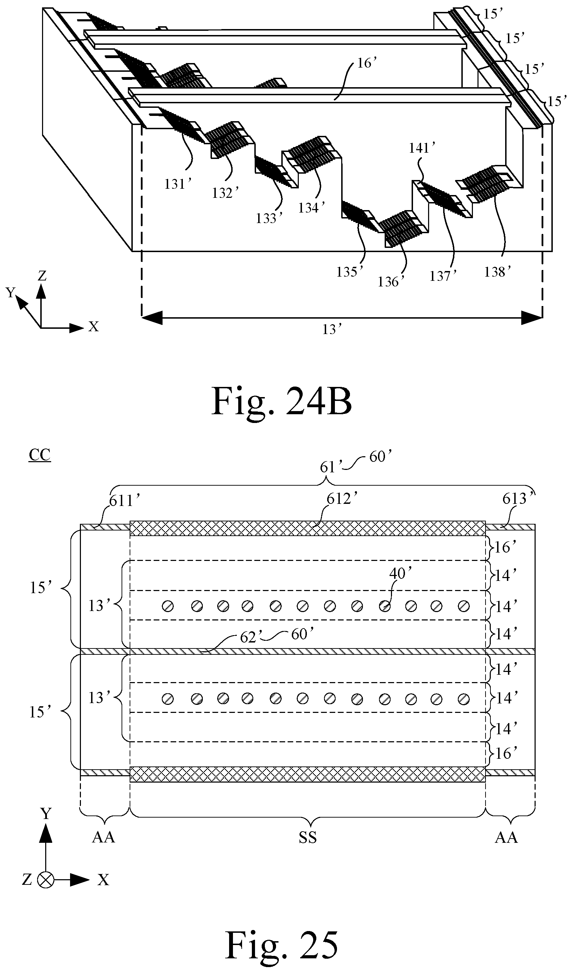

It is appreciated that the above-described step structure 13' is located in the step region SS. When the step region SS is located between two core array regions AA, the topography of the step structure 13' may be as shown in Figs. 24A and 24B. That is, in the first direction X, the step structure 13' may include at least one step group in which a plurality of steps 141' have heights increasing or decreasing gradually.

Illustratively, as shown in Figs. 24A and 24B, in the first direction X, the step structure 13' may include 8 step groups, which are a first step group 131', a second step group 132', a third step group 133', a fourth step group 134', a fifth step group 135', a sixth step group 136', a seventh step group 137' and an eighth step group 138' sequentially. In the first direction X, the plurality of steps 141' in the first step group 131', the third step group 133', the fifth step group 135' and the seventh step group 137' have heights decreasing gradually. In the first direction X, the plurality of steps 141' in the second step group 132', the fourth step group 134', the sixth step group 136' and the eighth step group 138' have heights increasing gradually. Of course, forms of the step structures 13' in the present disclosure are not limited thereto.

In the three-dimensional memory 300 provided in some examples of the present disclosure, a plurality of first stops 20' are disposed on at least one staircase structure 14' in the step structure 13'. Therefore, when forming the contact hole 51' where the contact post 50' is located, it is possible to remove a part of the protection layer on the first stop 20' with an etching process such as wet etching to expose a part of the first stop 20', then remove the exposed part of the first stop 20' and the separating layer 30' and the dielectric layer 12' between the first stop 20' and the underlying gate layer 11' with the etching process to expose a part of the gate layer 11'.

In the first etching process, due to the presence of the first stop 20', contact holes 51' with different depths corresponding to the steps 141' with different heights may stop at the respective first stops 20' on the steps 141'. In the second etching process, since distances between the respective first stops 20' and the gate layers 11' of the steps 141' where the first stops 20' are located are approximately the same, then in the second etching process, while etching for the same time, contact holes 51' with different depths corresponding to the steps 141' with different heights may stop at the respective gate layers 11' on the steps 141'.

Thus, while forming the contact post 50' in the contact hole 51', the contact post 50' may contact the gate layer 11' of the corresponding step 141', facilitating avoiding shorting among the plurality of gate layers due to the contact post extending through the plurality of gate layers resulting from the increase of the number of layers in the stack structure, thereby improving the electrical performance and yield of the three-dimensional memory.

At the same time, by providing the first stops 20', it is also possible to allow the contact holes 51' to have a faster etching speed and the contact holes 51' (or contact posts 50') to have a better linearity. This in turn makes the dielectric layer in the dummy channel structure adjacent to the contact post 50' is not prone to be etched, thereby improving the yield of the three-dimensional memory 300.

Referring to Figs. 18-23, in some examples, the three-dimensional memory 300 further includes isolation structures 60'. The isolation structures 60' extend in the first direction X and through the stack structure 10'. The isolation structures 60' divide the stack structure 10' into a plurality of memory blocks 15'. Each memory block 15' includes a step structure 13'. The staircase structures 14' where the first stops 20' are located are disposed at intervals with the isolation structures 60'.

It is appreciated that the isolation structure 60' may extend through the stack structure 10' and also extend through the separating layer 30'.

By "the staircase structures 14' where the first stops 20' are located are disposed at intervals with the isolation structures 60''', it means the first stops 20' are disposed at intervals with the isolation structures 60'.

In some examples of the present disclosure, the stack structure 10' is divided into a plurality of memory blocks 15' with the isolation structures 60', which may further improve the memory density of the three-dimensional memory 300. Meanwhile, the staircase structures 14' where the first stops 20' are located are disposed at intervals with the isolation structures 60', which may also avoid the case in which the first stop 20' is replaced in the subsequent process of forming the gate layer 11' by performing gate replacement by using the slit where the isolation structure is located, thereby causing the contact posts to penetrate through the replaced first stop and be electrically connected with the plurality of gate layers, thus resulting in failure of three-dimensional memory.

In some examples, referring to Figs. 20 and 21, in the second direction Y, the memory block 15' includes a first staircase structure 14A', a second staircase structure 14B' and a third staircase structure 14C', and the first stops 20' are disposed on the plurality of steps 141' of the second staircase structure 14B'.

Thus, the second staircase structure 14B' has height difference in the third direction Z with both the first staircase structure 14A' and the third staircase structure 14C' and is disposed at intervals with the isolation structure 60' (that is, the first staircase structure 14A' and the third staircase structure 14C' are between the second staircase structure 14B' and the isolation structures 60'), which facilitates preventing the first stop 20' from being replaced.

In some other examples, referring to Fig. 23, in the second direction Y, the memory block 15' includes a first staircase structure 14A' and a second staircase structure 14B', the first staircase structure 14A' is disposed at intervals with the isolation structure 60', and the first stops 20' are disposed on the plurality of steps 141' of the first staircase structure 14A'.

As such, the first staircase structure 14A' has height difference in the third direction Z with the second staircase structure 14B' and is disposed at intervals with the isolation structure 60', which facilitates preventing the first stop 20' from being replaced.

In some examples, referring to Figs. 20-24B, each memory block 15' further includes a sidewall 16'. The isolation structures 60' include a first isolation structure 61' and a second isolation structure 62'. In the second direction Y, the first isolation structure 61' is located between two adjacent sidewalls 16', and the second isolation structure 62' is located between two adjacent step structures 13'. The sidewall 16' is configured to enhance the structure stability of the three-dimensional memory 300.

In some examples, as shown in Figs. 18 and 22, the first isolation structure 61' may be an integral structure. That is, when fabricating the first isolation structure 61', it is possible to obtain the slit where the first isolation structure 61' is located by etching with one etching process and form the first isolation structure 61' in the slit.

In some other examples, as shown in Fig. 25, the first isolation structure 61' may include a first isolation sub portion 611', a second isolation sub portion 612' and a third isolation sub portion 613' connected sequentially in the first direction X. The second isolation sub portion 612' has a size in the second direction Y larger than that of the first isolation sub portion 611' and larger than that of the third isolation sub portion 613'.

Illustratively, the first isolation sub portion 611' and the third isolation sub portion 613' are located in the core array region AA, and the second isolation sub portion 612' is located in the step region SS and contacts the sidewall 16'.

Illustratively, the second isolation sub portion 612' may be fabricated simultaneously with the dummy channel structure and channel structure. The first isolation sub portion 611' and the third isolation sub portion 613' may be fabricated after completing fabrication of the channel structure. Based on this, the material for the second isolation sub portion 612' may be the same as the material for the dummy channel structure or channel structure.

In some examples of the present disclosure, by providing the second isolation sub portion 612', it is possible on one hand to separate two adjacent memory blocks 15' and on the other hand to support the stack structure 10', preventing the stack structure 10' from collapsing.

In some examples, referring to Figs. 22, 25 and 26, in the second direction Y, the step structures 13' in the two memory blocks 15' adjacent to the second isolation structure 62' are disposed symmetrically.

It is appreciated that, by "the step structures 13' in the two memory blocks 15' are disposed symmetrically", it might means that the number of staircase structures 14' included in the step structures 13' of the two memory blocks 15' is the same, and the two staircase structures 14' in the two step structures 13' that have equal distance from the second isolation structure 52' have the same heights.

In some examples, referring to Figs. 20 and 23, in the second direction Y and along a direction from the first isolation structure 61' toward the second isolation structure 62', the heights of the plurality of staircase structures 14' in the memory block 15' decrease gradually.

In some other examples, referring to Fig. 21, in the second direction Y and along a direction from the first isolation structure 61' toward the second isolation structure 62', the heights of the plurality of staircase structures 14' in the memory block 15' decrease first and then increase.

In some examples, referring to Figs. 20 and 21, in the second direction Y, the two staircase structures 14' adjacent to both sides of the second isolation structure 62' have the same heights.

In some examples, referring to Figs. 20, 21 and 23, the three-dimensional memory 300 further includes a plurality of second stops 70' disposed in the first direction X. The plurality of second stops 70' are located on the plurality of steps of other staircase structures 14' among the plurality of staircase structures 14' other than the staircase structures 14' on which the first stops 20' are disposed.

The separating layer 30' is also located between the step structure 13' and the second stop 70'. Similarly, it is appreciated that, as shown in Fig. 23, by "the separating layer 30' is also located between the step structure 13' and the plurality of second stop 70''', it means that in the third direction Z, the separating layer 30' is located between the second stop 70' and the step 141' of the step structure 13', and in the first direction X and the second direction Y, the separating layer 30' is located between the second stop 70' and the step 141' adjacent to the second stop 70'. The protection layer 40' further covers the second stop 70'.

Illustratively, when the protection layer 40' further covers the second stop 70', in the first direction X, at least a part of the protection layer 40' is located between the side face of the second stop 70' and the separating layer 30', and in the second direction Y, at least a part of the protection layer 40' is located between the side face of the second stop 70' and the separating layer 30'.

Illustratively, referring to Figs. 20 and 21, when the first stops 20' are located on the plurality of steps 141' of the second staircase structure 14B', the second stops 70' may be located on the plurality of steps 141' of the first staircase structure 14A' and the third staircase structure 14C'.

Illustratively, referring to Fig. 23, when the first stops 20' are located on the plurality of steps 141' of the first staircase structure 14A', the second stops 70' may be located on the plurality of steps 141' of the second staircase structure 14B'.

In some examples, the material for the first stop 20' and the second stop 70' may be the same.

Based on this, material for the first stop 20' and the second stop 70' may include for example carbon doped silicon nitride or silicon nitride.

In some examples, the materials for the first stop 20' and the second stop 70' may be different.

Illustratively, the material for the first stop 20' may be for example silicon nitride.

In case that the material for the first stop 20' includes silicon nitride or carbon doped silicon nitride, the material for the first stop 20' and the material for the gate layer 11' are different, and the etch selection ratio for the first stop 20' and that for the gate layer 11' are different. The first stops 20' are prone to be etched through when forming the contact holes with etch process. Therefore, when fabricating the contact holes 51' where the contact posts 50' are located, it is possible to first make the plurality of contact holes 51' corresponding to the steps 141' with different heights to stop at the first stops 20', with the distances between bottoms of respective contact holes 51' and the steps 141' approximately the same; and then etch the first stops 20' exposed by the plurality of contact holes 51' and etch the separating layer 30' and the dielectric layer 12' under the first stops 20' with the etching process, such that the contact holes 51' expose the gate layers 11' in their corresponding steps 141'. Therefore, the problem that the contact hole penetrates through the steps in higher layers, and shorting occurs between gate layers in adjacent steps of the higher layers after filling conductive material in the contact holes to form the contact posts is avoided, and the electrical performance and yield of three-dimensional memory are improved.

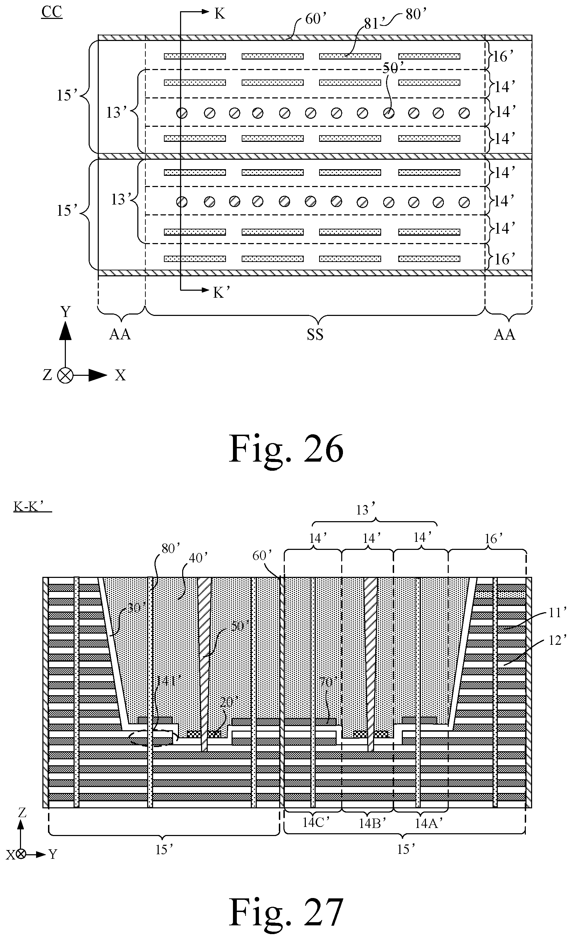

In some examples, as shown in Figs. 26 and 27, the three-dimensional memory 300 further includes a plurality of gate line isolation structures 80' extending in the first direction X and located between two adjacent isolation structures 60'. The gate line isolation structure 80' extends through the second stop 70' and the stack structure 10'. In the first direction X, each gate line isolation structure 80' includes a plurality of sub isolation structures 81' separated from each other.

By "the gate line isolation structure 80' extends through the second stop 70' and the stack structure 10‴, it means that the slit where the gate line isolation structure 80' is located extends through the second stop 70' and the stack structure 10'.

Providing the gate line isolation structure 80' may also release stress for the three-dimensional memory 300.

In some examples, the thickness of the second stop 70' is less than or equal to the thickness of the gate layer 11', at this time, the material for the second stop 70' is the same as the material for the gate layer.

It is appreciated that when the thickness of the second stop 70' is less than or equal to the thickness of the gate layer 11', it is possible to replace the sacrificial layers in the initial stack structure 101' with the gate layers 11' using the slits where gate line isolation structures 80' are located, and replace the material for the second stops 70' with the material for the gate layer 11' simultaneously.

Based on this, in some examples, the second stop 70' may be a single-layered structure, which is the same as the gate layer 11. Then, the second stop 70' also includes a conductive layer 111'. The material for the conductive layer 111' includes, but not limited to tungsten, cobalt, copper, aluminum, or doped crystalline silicon, doped silicon and/or silicide.

In some other examples, the second stop 70' may be composite multiple-layered structure, which is the same as the gate layer 11'. Then, the second stop 70' may include a high dielectric constant layer 112', a metal compound layer 113' and a conductive layer 111', wherein the high dielectric constant layer 112' wraps the conductive layer 111' and the metal compound layer 113' is between the high dielectric constant layer 112' and the conductive layer 111'. The material for the high dielectric constant layer 112' may include for example aluminum oxide (Al₂O₃), and the material for the metal compound 113' may include for example tantalum nitride or titanium nitride.

In some other examples, the thickness of the second stop 70' is greater than the thickness of the gate layer 11', at this time, the material for the second stop 70' is the same as the material for the gate line isolation structure 80'.

Based on this, in some examples, the material for the second stop 70' and the material for the gate line isolation structure 80' may both include dielectric material such as silicon oxide and/or silicon nitride. In some other examples, the second stop 70' and the gate line isolation structure 80' may be of composite stack structure. For example, the second stop 70' (or gate line isolation structure 80') may include a dielectric material layer and a conductive material layer such as at least one of tungsten, cobalt, copper, aluminum or polysilicon disposed sequentially. In yet some other examples, the second stop 70' may include a dielectric material and a high dielectric constant layer wrapping the dielectric material. In yet some other examples, the second stop 70' may further include a composite stack structure and a high dielectric constant layer wrapping the composite stack structure.

Two types of three-dimensional memory are introduced above for addressing the technical problem that the higher gate layers are prone to be penetrated through by contact posts. The fabrication methods for the two types of three-dimensional memory will be described below respectively.

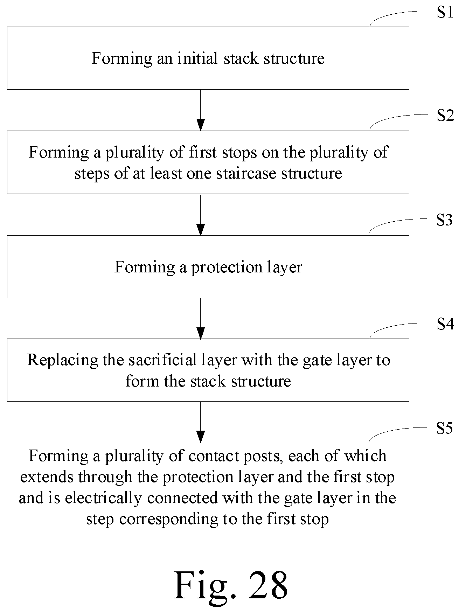

Referring to Fig. 28, some examples of the present disclosure provide a fabrication method for the three-dimensional memory 200, including operations S1-S5.

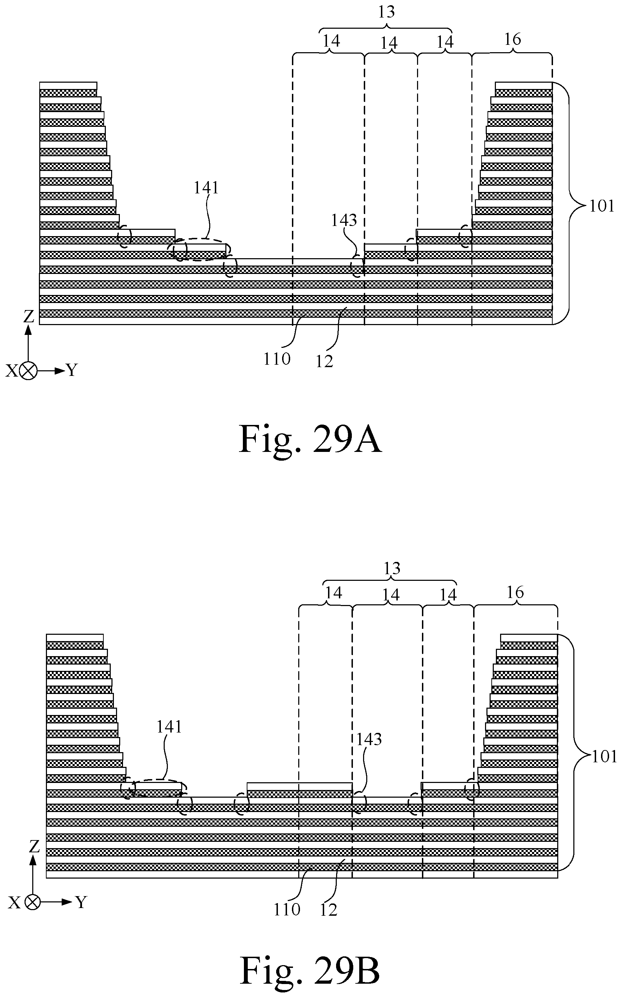

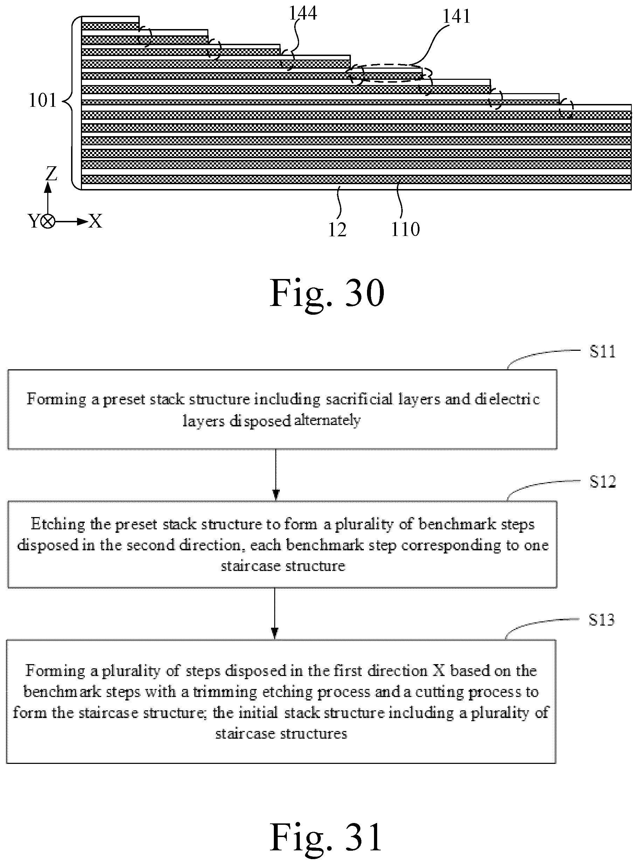

S1, referring to Figs. 29A, 29B and 30, forming an initial stack structure 101. The initial stack structure 101 includes a sacrificial layer 110 and a dielectric layer 12. The initial stack structure 101 includes a step structure 13 including a plurality of staircase structures 14 disposed in the first direction X and having different heights in the second direction Y. Each staircase structure 14 includes a plurality of steps 141. The first direction X is perpendicular to the second direction Y.

It is to be noted that the sacrificial layer 110 and the dielectric layer 12 may be formed by for example chemical vapor deposition (CVD) process, plasma-enhanced chemical vapor deposition (PECVD) process, high-density plasma chemical vapor deposition (HDP-CVD) process and atomic layer deposition (ALD) process or sputtering process.

Illustratively, the sacrificial layer 110 and the dielectric layer 12 have different etch selection ratio such that the sacrificial layer 110 may be removed in subsequent process while the dielectric layer 12 remains, thereby forming a gate line gap for forming the gate layer 11. Illustratively, the material for the sacrificial layer 110 may be silicon nitride, and the material for the dielectric layer 12 may be silicon oxide.

The number of sacrificial layers 110 and dielectric layers 12 in the initial stack structure 101 may be designed according to practical demands. Illustratively, the initial stack structure 101 may have 16 sacrificial layers 110 and dielectric layers 12, or 32 sacrificial layers 110 and dielectric layers 12. This is not limited in the present disclosure. It is noted that in the accompanying drawings provided in the present disclosure, the number of initial layer pairs are only illustrative and do not limit the present disclosure.

It is to be noted that in the initial stack structure 101, the thicknesses of the plurality of sacrificial layers 110 may be approximately the same or different. The thicknesses of the plurality of dielectric layers 12 may be approximately the same or different. It is possible to select the thicknesses of the plurality of sacrificial layers 110 and the plurality of dielectric layers 12 according to practical demands.

In some examples, as shown in Fig. 31, the operation S1 of forming the initial stack structure 101 includes:
S11, forming a preset stack structure 1011 including the sacrificial layers 110 and dielectric layers 12 disposed alternately.
S12, etching the preset stack structure 1011 to form a plurality of benchmark steps 142 disposed in the second direction Y. Each benchmark step 142 corresponds to one staircase structure 14.
S13, forming a plurality of steps 141 disposed in the first direction X based on the benchmark steps 142 with a trimming etching process and a cutting process to form the staircase structure 14. The initial stack structure 101 includes a plurality of staircase structures 14.

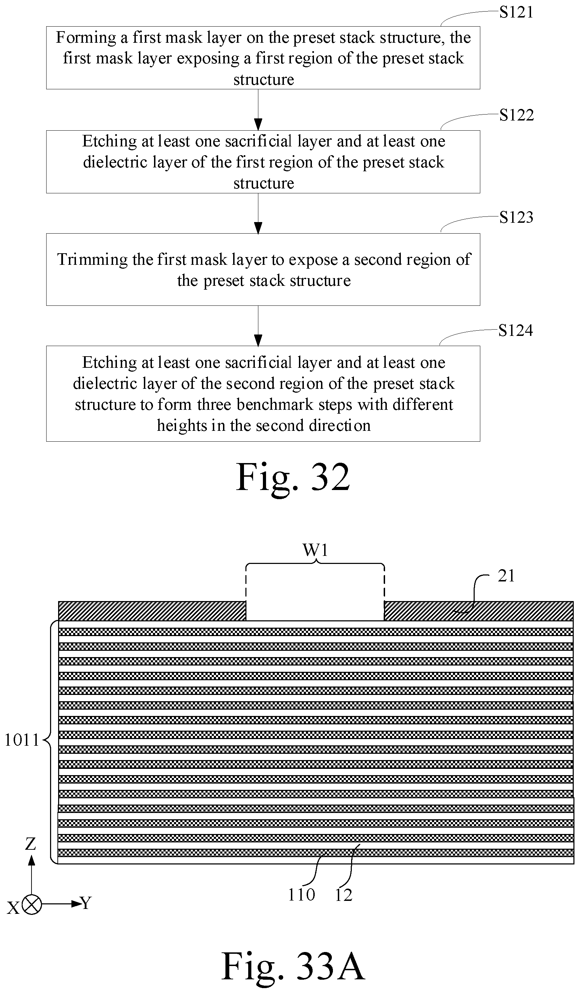

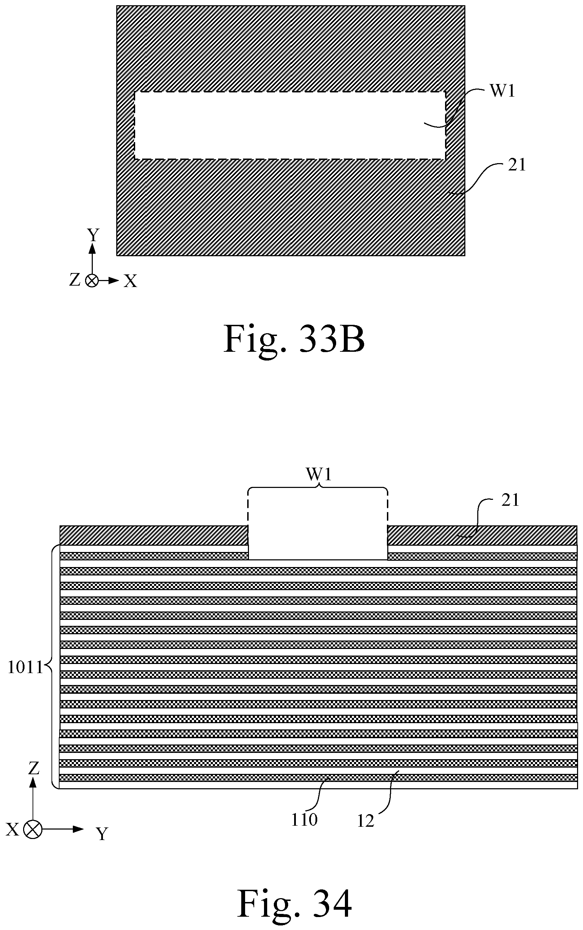

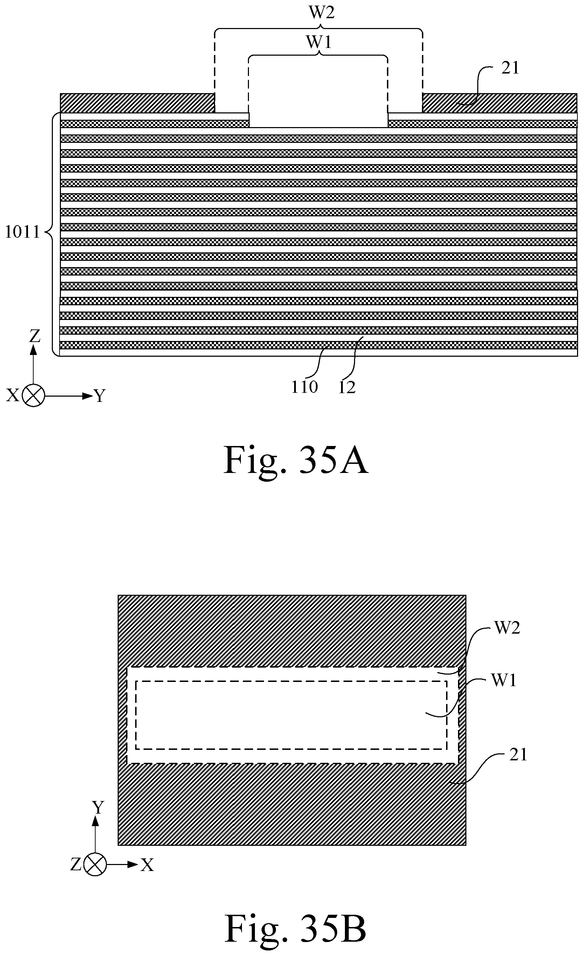

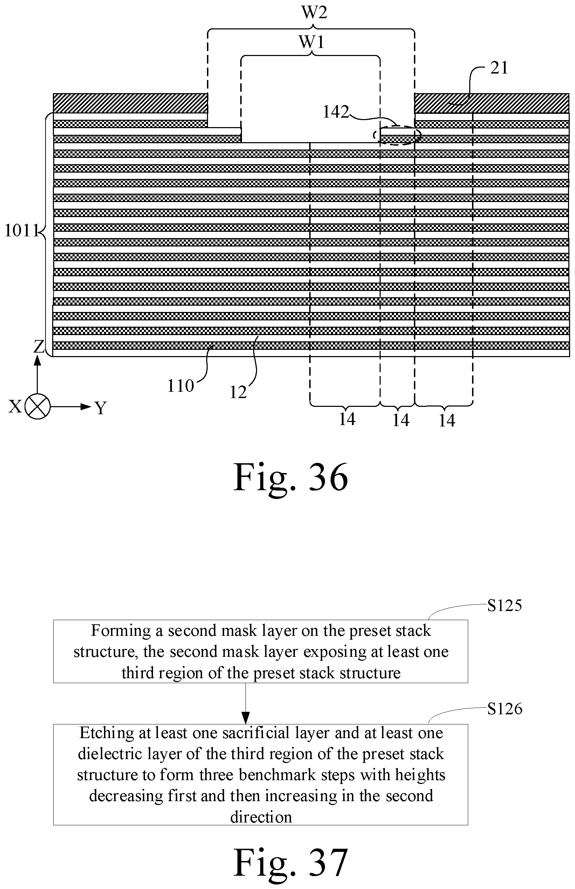

In some examples, as shown in Fig. 32, the operation S12 of etching the preset stack structure 1011 to form the plurality of benchmark steps 142 disposed in the second direction Y includes:
S121, as shown in Figs. 33A and 33B, forming a first mask layer 21 on the preset stack structure 1011. The first mask layer 21 exposes a first region W1 of the preset stack structure 1011.
S122, as shown in Fig. 34, etching at least one sacrificial layer 110 and at least one dielectric layer 12 of the first region W1 of the preset stack structure 1011.
S123, as shown in Figs. 35A and 35B, trimming the first mask layer 21 to expose a second region W2 of the preset stack structure 1011. The first region W1 is located inside the second region W2. Along the second direction Y, there is a spacing between the boundary of the first region W1 and the boundary of the second region W2.
S124, as shown in Fig. 36, etching at least one sacrificial layer 110 and at least one dielectric layer 12 of the second region W2 of the preset stack structure 1011 to form three benchmark steps 142 with different heights in the second direction Y.

Illustratively, in the operation S122, it is possible to etch one sacrificial layer 110 and one dielectric layer 12 of the first region W1 of the preset stack structure 1011, and in the operation S124, it is possible to etch one sacrificial layer 110 and one dielectric layer 12 of the second region W2 of the preset stack structure 1011 to form three benchmark steps 142 with different heights in the second direction Y.

When etching one sacrificial layer 110 and one dielectric layer 12 of the first region W1 of the preset stack structure 1011 in the operation S122, and etching one sacrificial layer 110 and one dielectric layer 12 of the second region W2 of the preset stack structure 1011 in the operation S124, the difference between the heights of two adjacent staircase structures 14 in the third direction Z is the height corresponding to one sacrificial layer 110 and one dielectric layer 12.

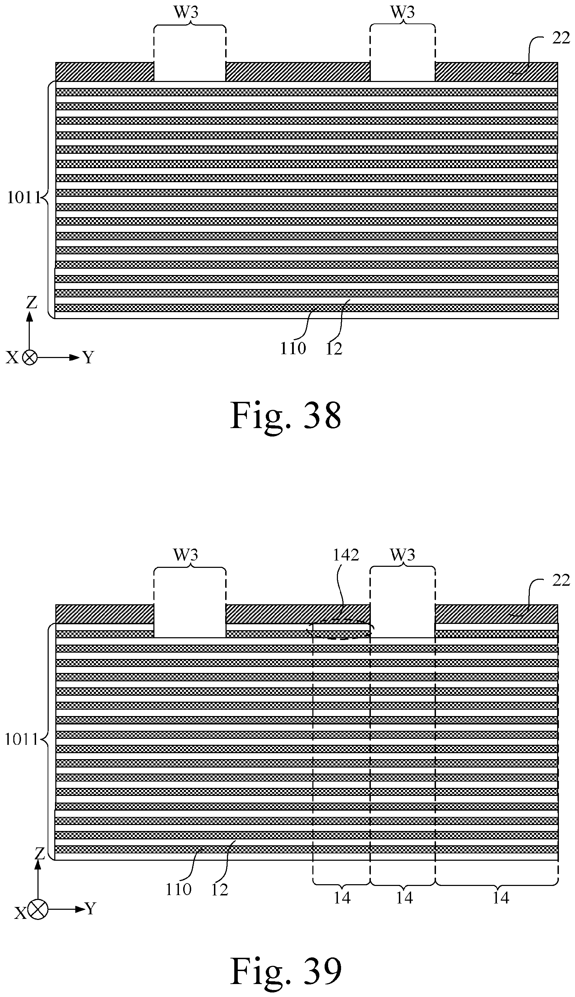

In some other examples, as shown in Fig. 37, the operation S12 of etching the preset stack structure 1011 to form the plurality of benchmark steps 142 disposed in the second direction Y includes:
S125, as shown in Fig. 38, forming a second mask layer 22 on the preset stack structure 1011. The second mask layer 22 exposes at least one third region W3 of the preset stack structure 1011.

Fig. 38 shows an example in which the second mask layer 22 exposes two third regions W3, which is not limited in the present disclosure.

S126, as shown in Fig. 39, etching at least one sacrificial layer 110 and at least one dielectric layer 12 of the third region W3 of the preset stack structure 1011 to form three benchmark steps 142 with heights decreasing first and then increasing in the second direction Y.

Illustratively, it is possible to etch the preset stack structure 1011 with wet etching process or dry etching process.

It is to be noted that the above operations have been described by taking forming three benchmark steps 142 as an example, and in other examples, it is also possible to form two or more than three benchmark steps 142.

Illustratively, when the step structure 13 includes two staircase structures 14, two staircase structures 14 may be obtained simply with the operations S121, S122 and S13.

Illustratively, when the step structure 13 includes more than three staircase structures 14, after operations S121-S124, it is also possible to trim the first mask layer 21 for multiple times such that the area of the initial stack structure exposed by the first mask layer 21 is larger and larger. After each time the first mask layer 21 is trimmed, at least one initial layer pair 102 of the part of the initial stack structure 101 that is exposed by the first mask layer 21 is etched to form more than three benchmark steps 142, thereby forming more than three staircase structures 14.

It is to be noted that after obtaining the plurality of staircase structures 14, the trimmed first mask layer 21 or the second mask layer 22 needs to be removed.

Illustratively, in the operation S13, while forming a plurality of steps 141 disposed in the first direction X based on the benchmark steps 142 with the trimming etching process and the cutting process to form the staircase structure 14, it is also possible to form a sidewall 16.

S2, forming the plurality of first stops 20 on the plurality of steps 141 of at least one staircase structure 14. The plurality of first stops 20 are disposed in the first direction X, with each first stop 20 on one step 141.

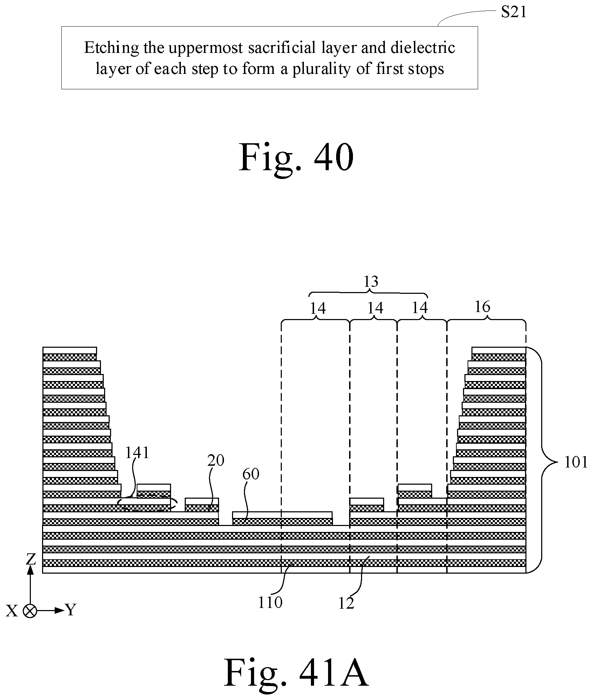

In some examples, as shown in Fig. 40, the operation S2 of forming the plurality of first stops 20 on the plurality of steps 141 of at least one staircase structure 14 includes:
S21, etching the uppermost sacrificial layer 110 and dielectric layer 12 of each step 141 to form the plurality of first stops 20.

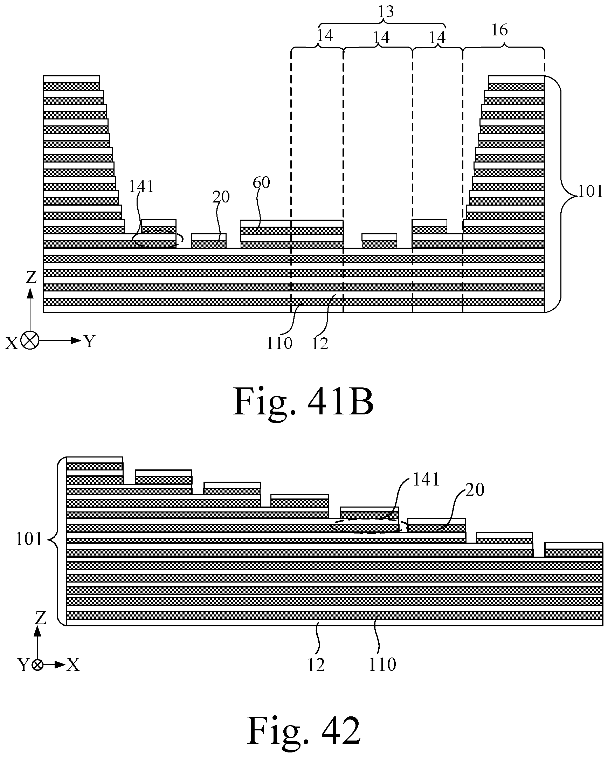

Referring to Figs. 29A, 41A, 29B and 41B, etching the uppermost sacrificial layer 110 and dielectric layer 12 of the each step 141 may be for example etching parts 143 of the sacrificial layers 110 and the dielectric layers 12 at the junctions with steps 141 in the second direction Y. Referring to Figs. 30 and 42, etching the uppermost sacrificial layer 110 and dielectric layer 12 of the each step 141 may be for example etching parts 144 of the sacrificial layers 110 and the dielectric layers 12 at the junctions with steps 141 in the first direction X.

In this manner, by etching the uppermost sacrificial layer 110 and the dielectric layer 12 of each step 141 to remove parts of the uppermost sacrificial layer 110 and dielectric layer 12 at the junctions with steps 141, in order to form the plurality of first stops 20, the need for separately depositing additional films is eliminated, thereby reducing the fabrication process and fabrication costs of the three-dimensional memory 200.

At the same time, there is a spacing between the formed first stop 20 and the step, such that the first stop 20 is not prone to be replaced in the subsequent process of replacing the sacrificial layer 110 with the gate layer 11. Therefore, in the subsequent process of forming contact holes 41, the contact holes 41 corresponding to different steps 141 can first stop at their corresponding first stops 20 after the first etching, and then stop at the gate layers 11 after the second etching, thereby the problem that the contact hole penetrates through the steps in higher layers, and shorting occurs between steps of the higher layers after forming the contact post is avoided.

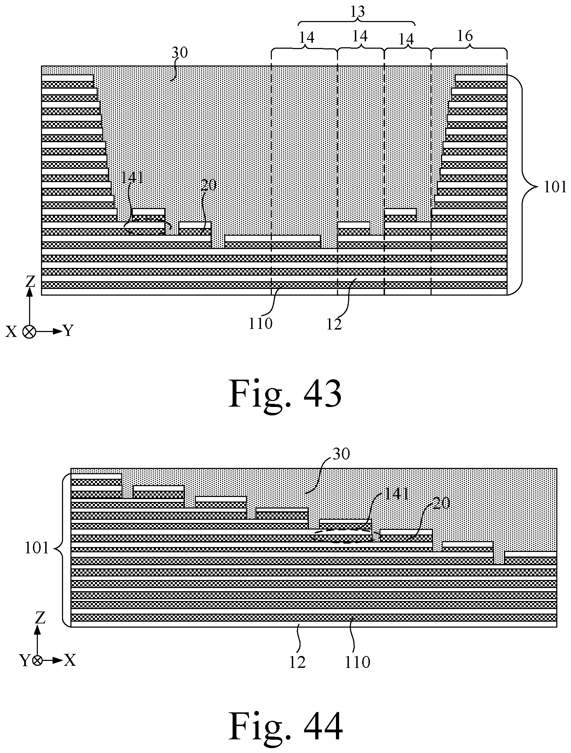

S3, referring to Figs. 43 and 44, forming a protection layer 30. The protection layer 30 covers the step structure 13 and the first stop 20 and at least a part of the protection layer 30 is located between the first stop 20 and the step 141 adjacent to the first stop 20.

The protection layer 30 may be made of silicon oxide, including, but not limited to tetraethoxysilane (TEOS), siloxane, silsesquioxane etc.

Illustratively, the protection layer 30 may be formed by chemical vapor deposition (CVD) process, spin coating process etc.

Illustratively, after forming the protection layer 30, it is also possible to planarize it with chemical mechanical polishing (CMP) process.

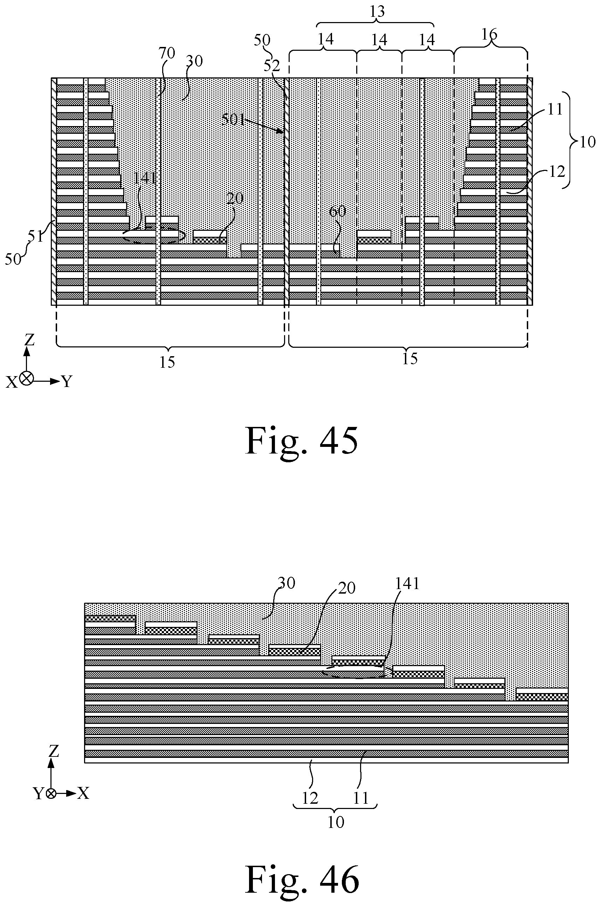

S4, referring to Figs. 45 and 46, replacing the sacrificial layer 110 with the gate layer 11 to form the stack structure 10.

In some examples, the three-dimensional memory 200 includes isolation structures 50 including a first isolation structure 51 and a second isolation structure 52, both of which are of an integral structure.

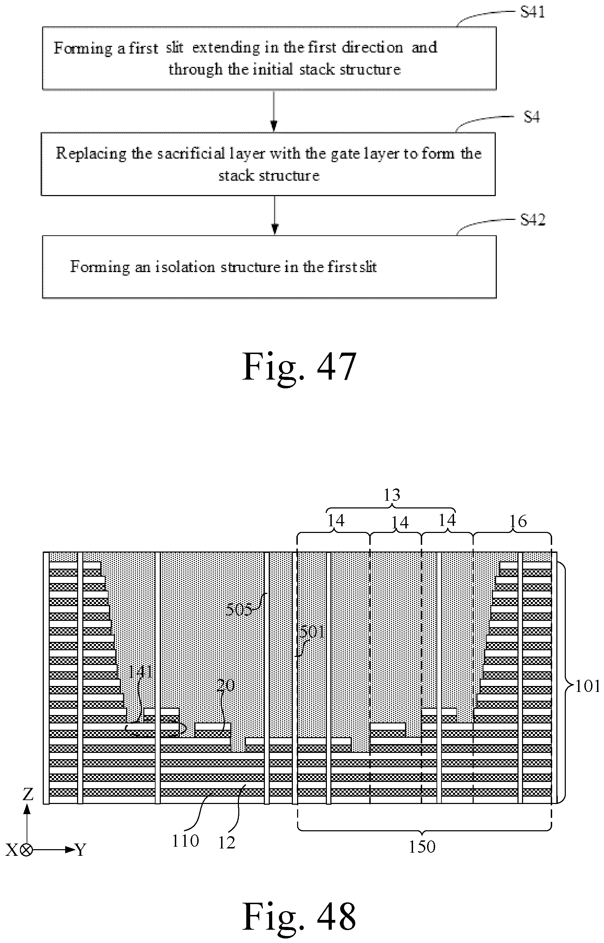

Based on this, in some examples, as shown in Fig. 47, the fabrication method further includes:
S41, referring to Fig. 48, forming a first slit 501 extending in the first direction X and extending through the initial stack structure 101, the first slit 501 dividing the initial stack structure 101 into a plurality of initial memory blocks 150, with each initial memory block 150 including the step structure 13.

Illustratively, it is possible to form the first slit 501 with the dry etching process. The first slit 501 extends through the initial stack structure 101 in the third direction Z.

Illustratively, it is possible to replace the sacrificial layer 110 with the gate layer 11 by using the first slit 501. Illustratively, it is possible to introduce the etching solution from the first slit 501 into the initial stack structure 101 with the wet etching process. At this time, since the sacrificial layer 10 and the dielectric layer 12 have different etching selection ratio, in the etching process, the sacrificial layer 110 can be etched, and the dielectric layer 12 can remain, thereby forming a cavity in the corresponding formed part.

Illustratively, it is possible to form the gate layer 11 in the cavity with one or more processes of CVD, PVD and ALD.

The gate layer 11 may be of a single-layered structure. For example, the gate layer 11 includes a conductive material, including, but not limited to tungsten, cobalt, copper, aluminum, or doped crystalline silicon. Alternatively, the gate layer 11 may be of a multilayer composite structure. For example, the gate layer 11 may include a high dielectric constant layer (such as aluminum oxide Al₂O₃), a metal compound layer (such as tantalum nitride or titanium nitride) and a conductive layer (such as tungsten) formed sequentially.

In some examples, as shown in Fig. 47, the fabrication method further includes:
S42, as shown in Fig. 45, forming the isolation structure 50 in the first slit 501.

Illustratively, the isolation structure 50 may be formed with one or more processes of CVD, PVD and ALD. The isolation structure 50 may include only one or more dielectric material layers, and may also include one or more dielectric material layers and at least one conductive material layer disposed sequentially.

The isolation structure 50 may divide the stack structure 10 into a plurality of memory blocks 15, which allows further improving the memory density of the three-dimensional memory 200.

In some other examples, as shown in Fig. 13, the three-dimensional memory 200 includes the isolation structures 50 including the first isolation structure 51 and the second isolation structure 52. The first isolation structure 51 may include a first isolation sub portion 511, a second isolation sub portion 512 and a third isolation sub portion 513 connected sequentially in the first direction X.

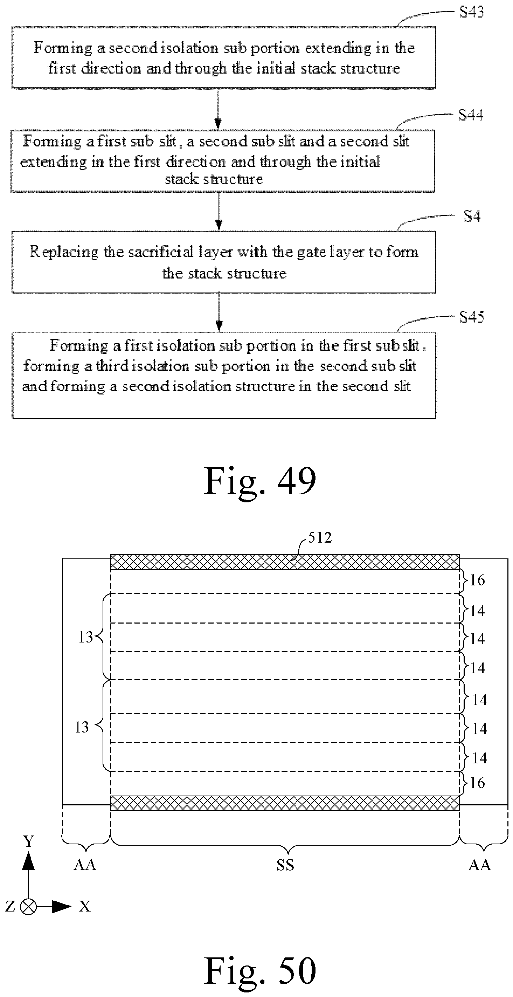

In some examples, as shown in Fig. 49, the fabrication method may further include:
S43, referring to Fig. 50, forming the second isolation sub portion 512 extending in the first direction X and through the initial stack structure 101.

Based on this, illustratively, the second isolation sub portion 512 may be fabricated simultaneously with the dummy channel structure and channel structure. For example, it is possible to form the second isolation sub portion 512 after forming the initial stack structure 101 and before forming the protection layer 30.

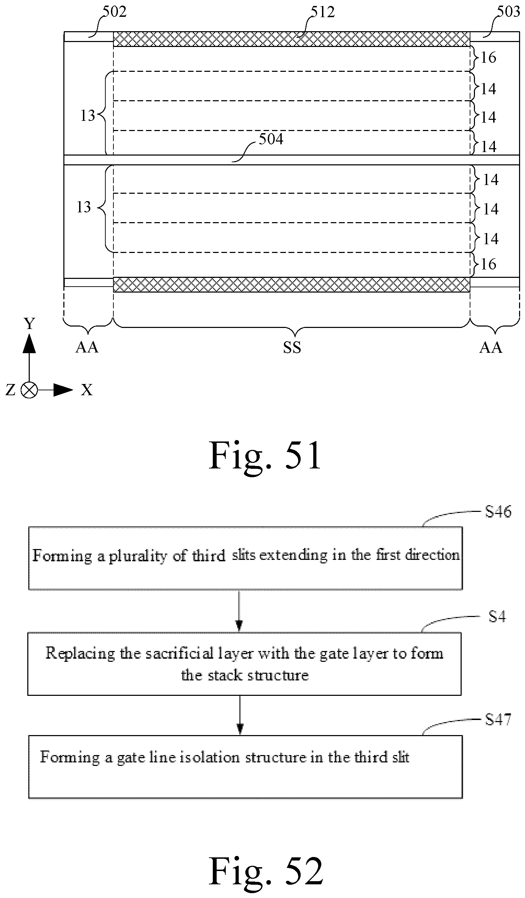

S44, referring to Fig. 51, forming a first sub slit 502, a second sub slit 503 and a second slit 504 extending in the first direction X and through the initial stack structure 101. In the first direction X, the first sub slit 502 and the second sub slit 503 contact both ends of the second isolation sub portion 512 respectively. In the second direction Y, the second slit 504 is located between two adjacent second isolation sub portions 512.

In some examples, as shown in Fig. 49, the fabrication method may further include:
S45, referring to Fig. 13, forming the first isolation sub portion 511 in the first sub slit 502, forming the third isolation sub portion 513 in the second sub slit 503 and forming a second isolation structure 52 in the second slit 504.

The first isolation sub portion 511, the third isolation sub portion 513 and a second isolation sub portion 512 constitute at least a part of the first isolation structure 51.

In some examples, referring to Figs. 41A, 41B and 42, the fabrication method may further include:

Forming the plurality of second stops 60 on the plurality of steps 141 of other staircase structures 14 among the plurality of staircase structures 14 other than the staircase structures 14 on which the first stops 20 are disposed.

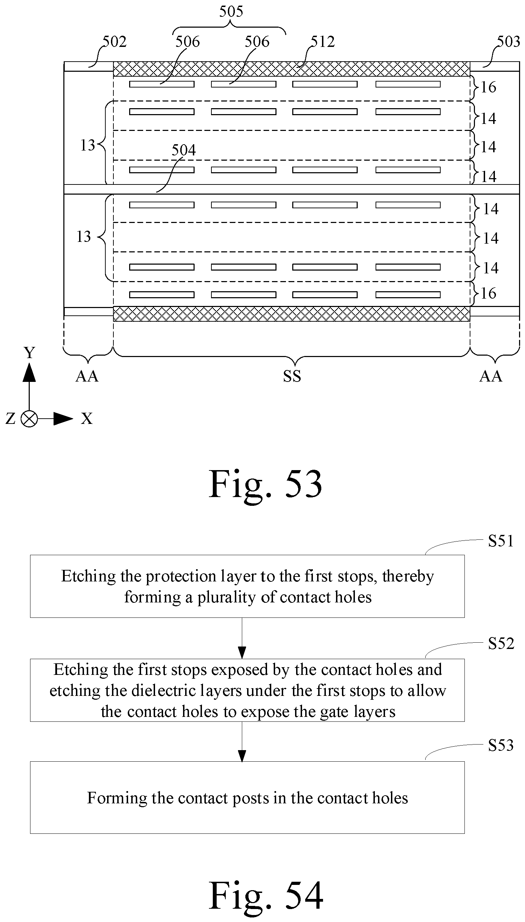

In some examples, referring to Fig. 52, the fabrication method may further include:
S46, referring to Fig. 53, forming a third slit 505 extending in the first direction X. The third slit 505 extends through the second stops 60 and the initial stack structure 101. Along the first direction X, each third slit 505 includes a plurality of third sub slits 506 separated from each other.

In some examples, referring to Fig. 41, the fabrication method further includes:
S47, referring to Fig. 45, forming a gate line isolation structure 70 in the third slit 505.

Illustratively, it is possible to form the plurality of third slits 505 extending in the first direction X after replacing, in the operation S4, the sacrificial layer 120 with the gate layer 11 to form the stack structure 10. It is possible to form the gate line isolation structure 70 in the third slit 505 after the operation S4.

In some examples, the third slit 505 may be formed simultaneously with the first slit 501. In some other examples, the third slit 505 may be formed simultaneously with the first sub slit 502, the second sub slit 503 and the second slit 504.

Thus, in the process of replacing the sacrificial layer 110 with the gate layer 11, it is possible to replace the material for the second stops with the material same as the gate layer 11 by using the plurality of third slits 505.

S5, referring to Figs. 6-11, forming a plurality of contact posts 40. The contact post 40 extends through the protection layer 30 and the first stop 20 and is electrically connected with the gate layer 11 in the step 141 corresponding to the first stop 20.

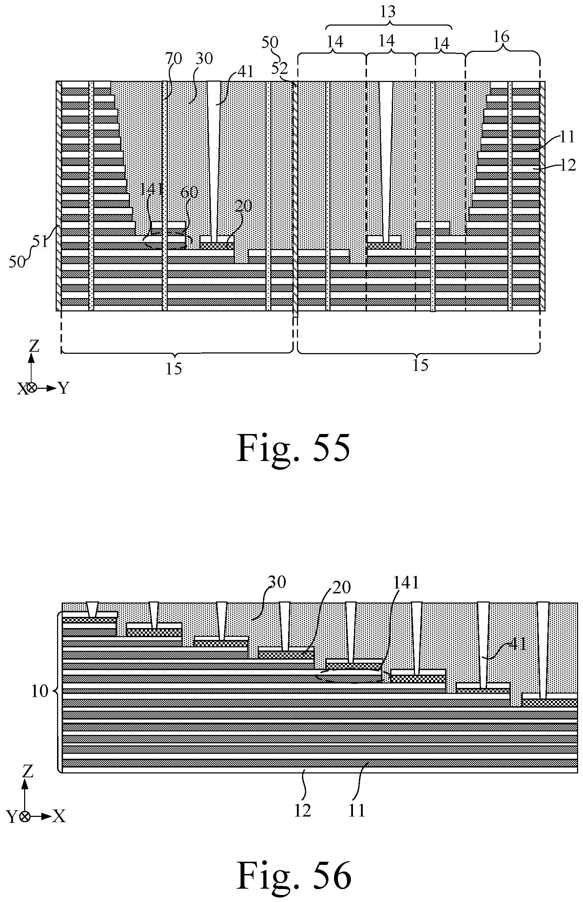

Illustratively, referring to Fig. 54, S5 of forming the plurality of contact posts 40 includes operations S51-S53:
S51, referring to Figs. 55 and 56, etching the protection layer 30 to the first stops 20 to form the plurality of contact holes 41.

Illustratively, it is possible to form the contact hole 41 with a wet etching process.

Since the first stop 20 and the gate layer 11 have different materials and different etching selection ratios, in the process of forming the contact hole 41, the first stop 20 is not prone to be etched through like the gate layer 11, the contact holes 41 corresponding to the steps 141 with different heights may all stop at the first stops 20 on their corresponding steps, thereby exposing the first stops 20.

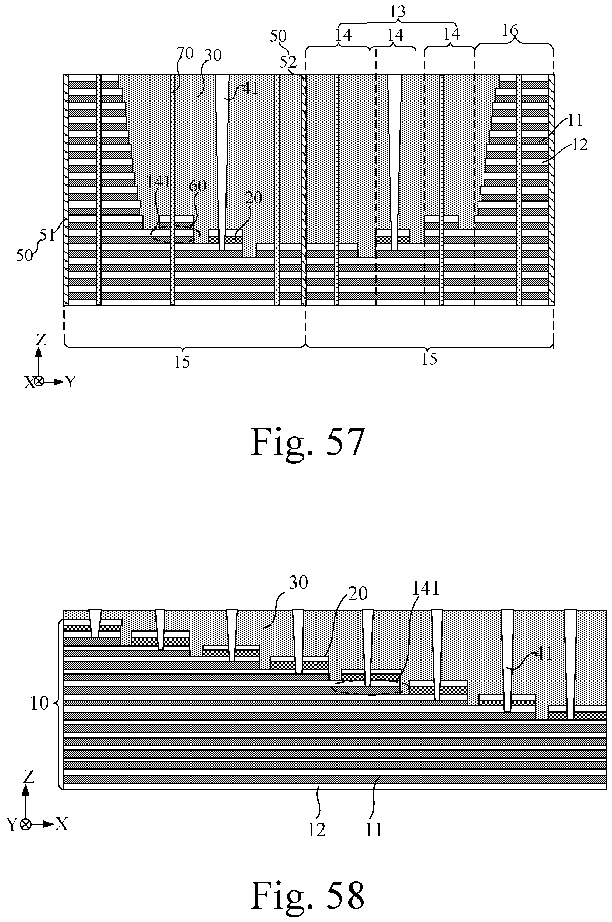

S52, referring to Figs. 57 and 58, etching the first stop 20 exposed by the contact hole 41 and etching the dielectric layer 12 under the first stop 20 to allow the contact hole 41 to expose the gate layer 11.

Illustratively, it is possible to etch the first stop 20 exposed by contact hole 41 and etch the dielectric layer 12 under the first stop 20 with a dry etching process to allow the contact hole 41 to expose the gate layer 11.

The first stops 20 on different steps 141 have approximately the same distances from the gate layers 11 in the steps 141. Therefore, it is possible to etch the same thickness of layers at different steps 141 to expose the gate layers 11. Thus, the contact holes 41 formed in a three-dimensional memory may all contact well with the gate layers 11 in the corresponding steps 141 and would not penetrate through the gate layers 11 in their corresponding steps, thereby effectively avoid the case in which the gate layers are penetrated, and different gate layers are shorted after forming the contact posts 40, hence improving electrical performance and yield of the three-dimensional memory.

S53, referring to Figs. 6-11, forming the contact post 40 in the contact hole 41.

Illustratively, it is possible to form the contact post 40 with one of CVD, PVD and ALD. The material for contact post 40 is a conductive material such as at least one of tungsten, cobalt, copper, aluminum, doped crystalline silicon or silicide.

Some examples of the present disclosure further provide a fabrication method of another three-dimensional memory 300, in which the fabrication method of the three-dimensional memory 200 as provided in the above-described examples may be referred to for the implementation of operations similar to those in the above-described examples.

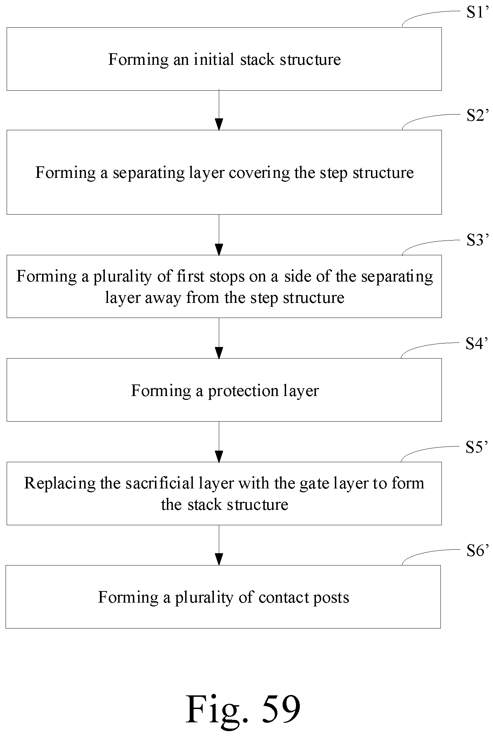

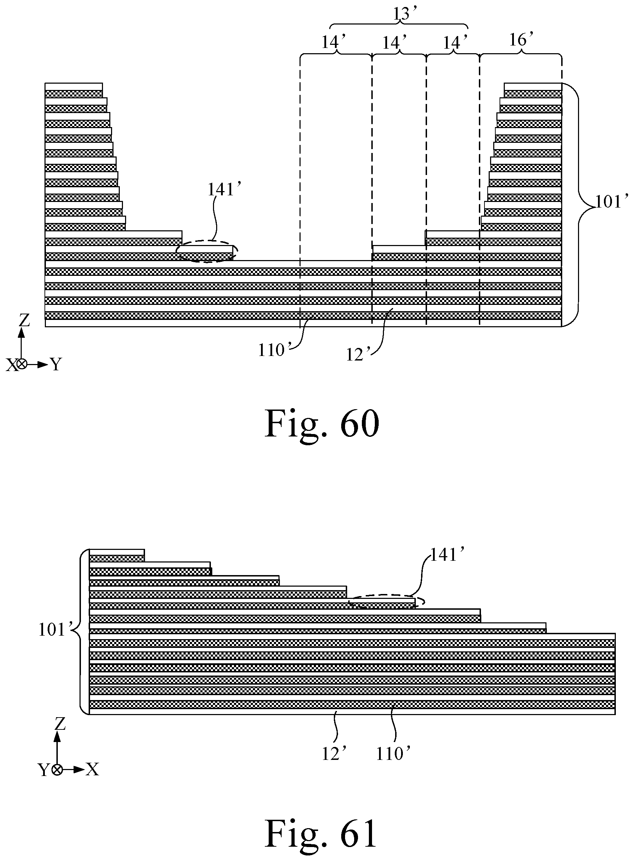

Referring to Fig. 59, the fabrication method for the three-dimensional memory 300 includes operations S1'-S6':
S1', referring to Figs. 60 and 61, forming an initial stack structure 101'. The initial stack structure 101' includes sacrificial layers 110' and dielectric layers 12' disposed alternately. The initial stack structure 101' includes an initial step structure 130' including a plurality of staircase structures 14' disposed in the first direction X and having different heights in the second direction Y. The staircase structure 14' includes a plurality of steps 141'. The first direction X is perpendicular to the second direction Y.

Similar to the fabrication method of the three-dimensional memory 200 as provided in the previous example, the sacrificial layer 110' and the dielectric layer 12' may be formed by for example chemical vapor deposition (CVD) process, plasma-enhanced chemical vapor deposition (PECVD) process, high-density plasma chemical vapor deposition (HDP-CVD) process and atomic layer deposition (ALD) process or sputtering process.

The sacrificial layer 110' and the dielectric layer 12' have different etch selection ratio, such that the sacrificial layer 110' may be removed in subsequent process, while the dielectric layer 12' remains, thereby forming a gate line gap for forming the gate layer 11'. Illustratively, the material for the sacrificial layer 110' may be silicon nitride, and the material for the dielectric layer 12' may be silicon oxide.

The number of the sacrificial layers 110' and the dielectric layers 12' in the initial stack structure 101' may be designed according to practical demands. Illustratively, the initial stack structure 101' may have 16 pairs of the sacrificial layers 110' and dielectric layers 12', or 32 pairs of the sacrificial layers 110' and dielectric layers 12', which is not limited in the present disclosure. It is noted that in the accompanying drawings provided in the present disclosure, the number of initial layer pairs 102' is only illustrative and does not limit the present disclosure.

It is to be noted that in the initial stack structure 101', the thicknesses of the plurality of sacrificial layers 110' may be approximately the same or different. The thicknesses of the plurality of dielectric layers 12' may be approximately the same or different. It is possible to select the thicknesses of the plurality of sacrificial layers 110' and the plurality of dielectric layers 12' according to practical demands.

The operations S11-S13 in the above-described fabrication method of three-dimensional memory 200 may be referred to for the process of forming the initial stack structure 101'.

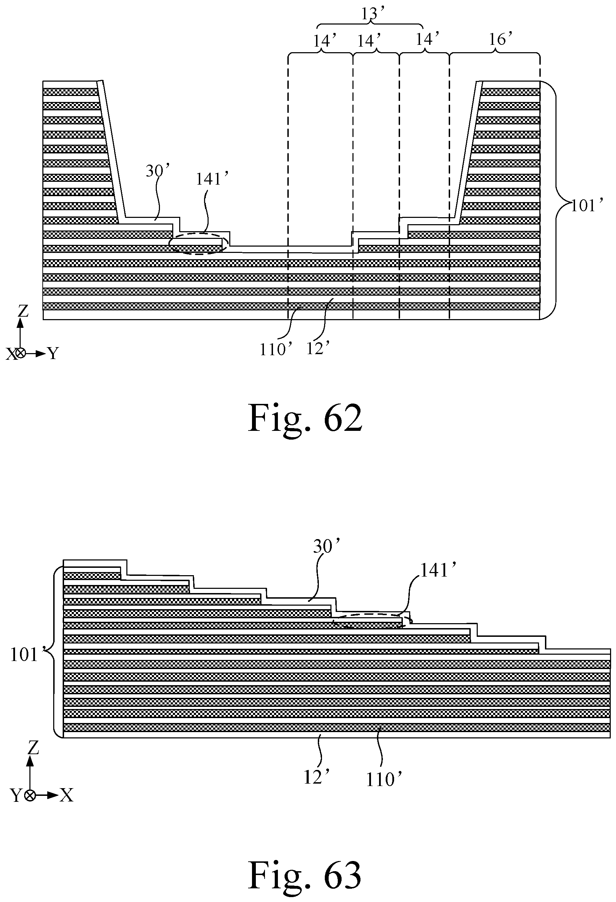

S2', as shown in Figs. 62 and 63, forming a separating layer 30' covering the step structure 13'.

Illustratively, the separating layer 30' may be made of insulating material, including, but not limited to silicon oxide, silicon nitride, silicon oxynitride or combinations thereof.

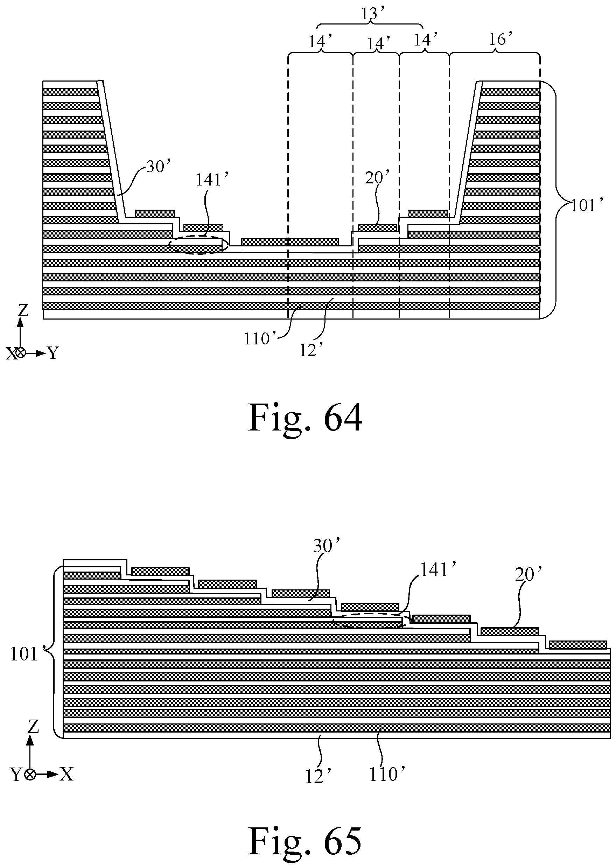

S3', referring to Figs. 64 and 65, forming a plurality of first stops 20' on a side of the separating layer 30' away from the step structure 13'. The plurality of first stops 20' are disposed in the first direction X and located on the plurality of steps 141' of at least one staircase structure 14', with each first stop 20' on one step 141'.

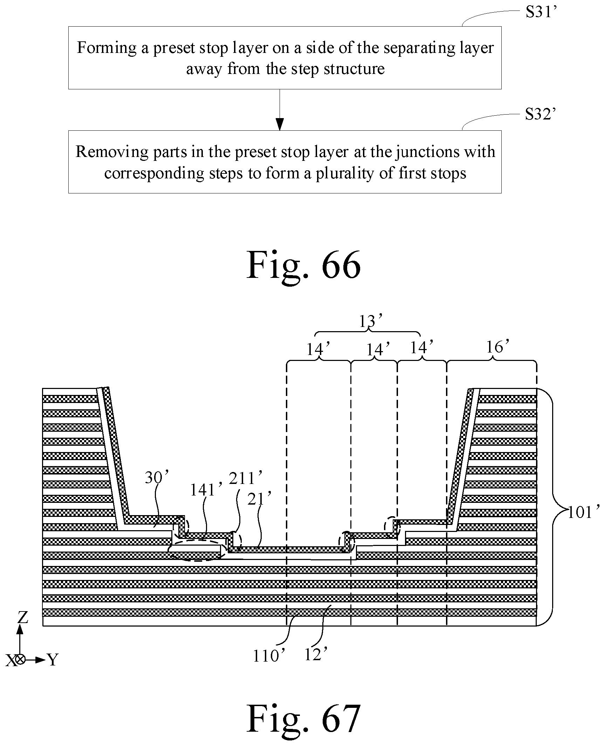

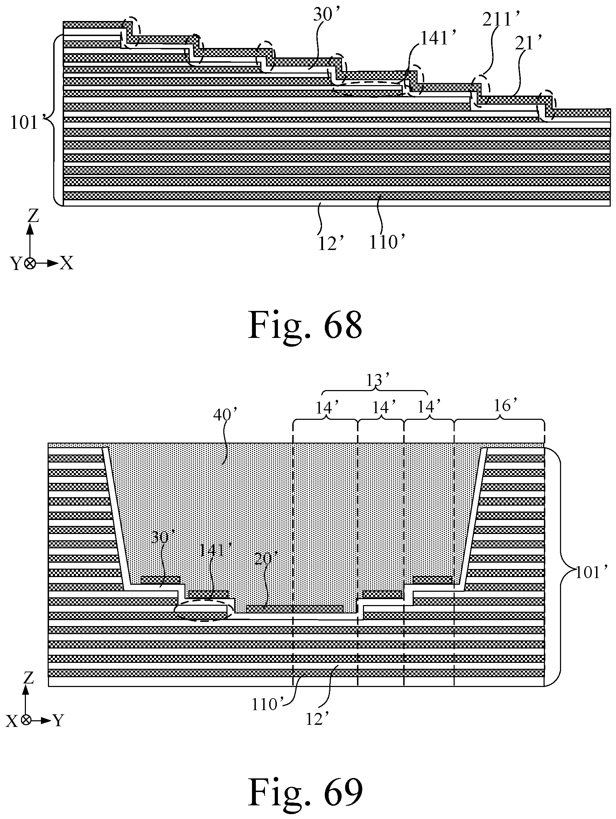

In some examples, referring to Fig. 66, the operation S3' of forming the plurality of first stops 20' on the side of the separating layer 30' away from the step structure 13' may include:
S31', referring to Figs. 67 and 68, forming a preset stop layer 21' on the side of the separating layer 30' away from the step structure 13'.
S32', referring to Figs. 64 and 65, removing parts 211' in the preset stop layer 21' at the junctions with corresponding steps 141' to form a plurality of first stops 20'.

In some examples, the material for the preset stop layer 21' may be the same as that for the sacrificial layer 120'.

In some examples, the material for the preset stop layer 21' may be different from that for the sacrificial layer 120'. At this time, illustratively, the material for the preset stop layer 21' may be carbon doped silicon nitride.

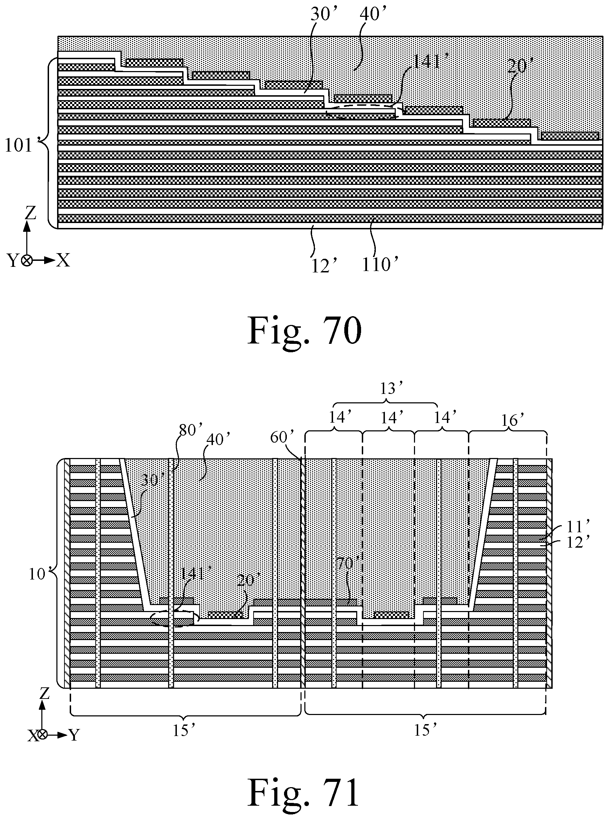

S4', referring to Figs. 69 and 70, forming a protection layer 40'. The protection layer 40' covers the separating layer 30' and the first stops 20'.

It is appreciated that, referring to Figs. 64 and 65, after forming the plurality of first stops 20', in the first direction X and the second direction Y, there is a gap between side face of the first stop 20' and the separating layer 30'. Thus, after subsequently forming the protection layer 40', at least a part of the protection layer 40' will fall into the gap between the side face of the first stop 20' and the separating layer 30'.

S5', referring to Fig. 71, replacing the sacrificial layer 110' with the gate layer 11' to form the stack structure 10'.

In some examples, the three-dimensional memory 300 further includes isolation structures 60'. The isolation structures 60' include a first isolation structure 61' and a second isolation structure 62', both of which are of an integral structure.

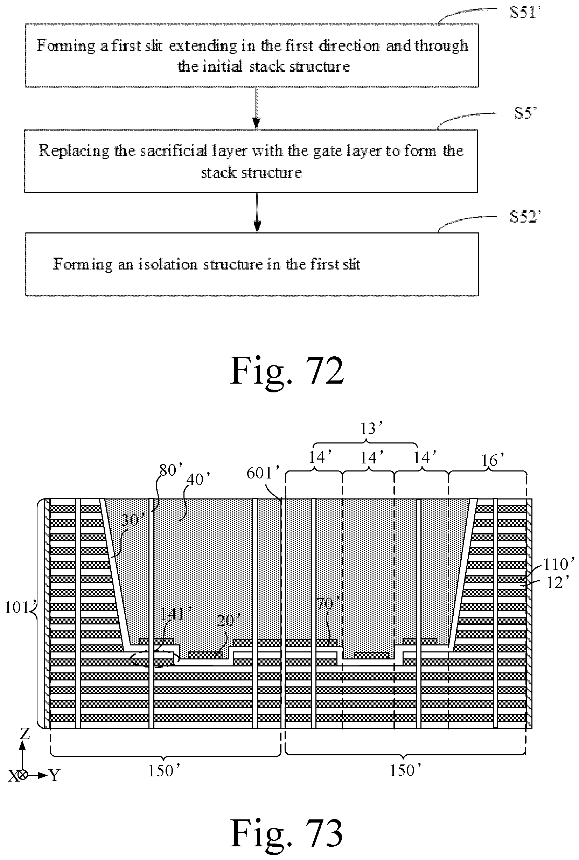

Based on this, in some examples, as shown in Fig. 72, the fabrication method may further include:
S51', referring to Fig. 73, forming a first slit 601' extending in the first direction X and through the initial stack structure 101', the first slit 601' dividing the initial stack structure 101' into a plurality of initial memory blocks 150'. Each initial memory block 150' includes the step structure 13'.

Illustratively, it is possible to form the first slit 601' with the dry etching process. The first slit 601' extends through the initial stack structure 101' in the third direction Z.

Illustratively, it is possible to replace the sacrificial layer 110' with the gate layer 11' using the first slit 601'. Illustratively, it is possible to introduce the etching solution from the first isolation 601' into the initial stack structure 101' with the wet etching process. At this time, since the sacrificial layer 110' and the dielectric layer 12' have different etching selection ratio, in the etching process, the sacrificial layer 110' can be etched, and the dielectric layer 12' can remain, thereby forming a cavity in the corresponding formed parts.

Illustratively, it is possible to form the gate layer 11' in the cavity with one or more processes of CVD, PVD and ALD.

In some examples, as shown in Fig. 72, the fabrication method may further include:
S52', referring to Fig. 71, forming the isolation structure 60' in the first slit 601'.

Illustratively, it is possible to form the isolation structure 60' with one or more processes of CVD, PVD and ALD. The isolation structure 60' may only include one or more dielectric material layers, and may also include one or more dielectric material layers and at least one conductive material layer disposed sequentially.

In some other examples, as shown in Fig. 25, the three-dimensional memory 300 includes the isolation structures 60' including a first isolation structure 61' and a second isolation structure 62'. The first isolation structure 61' may include a first isolation sub portion 611', a second isolation sub portion 612' and a third isolation sub portion 613' connected sequentially in the first direction X.

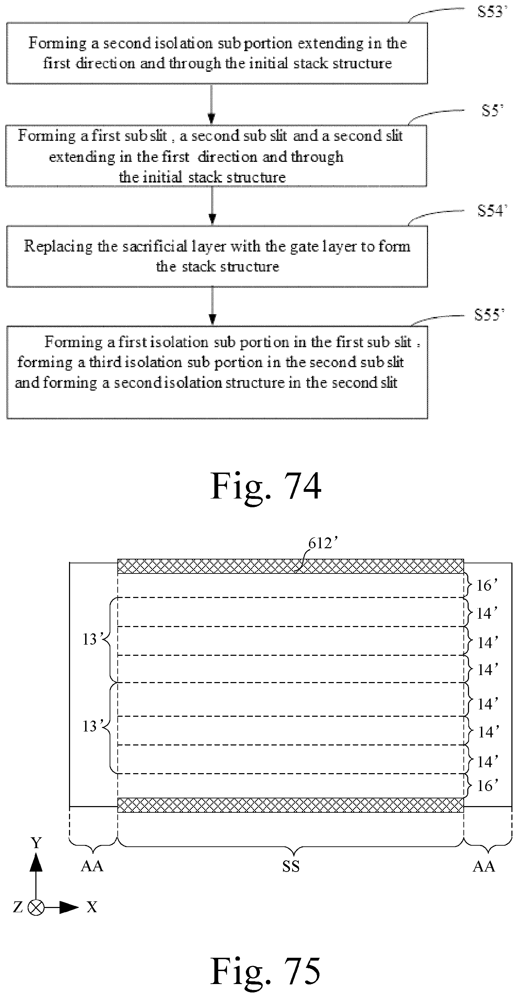

Based on this, in some examples, as shown in Fig. 74, the fabrication method may further include:
S53', referring to Fig. 75, forming the second isolation sub portion 612' extending in the first direction X and through the initial stack structure 101'.

Based on this, illustratively, the second isolation sub portion 612' may be fabricated simultaneously with the dummy channel structure and channel structure. For example, it is possible to form the second isolation sub portion 612' after forming the initial stack structure 101' and before forming the protection layer 40'.

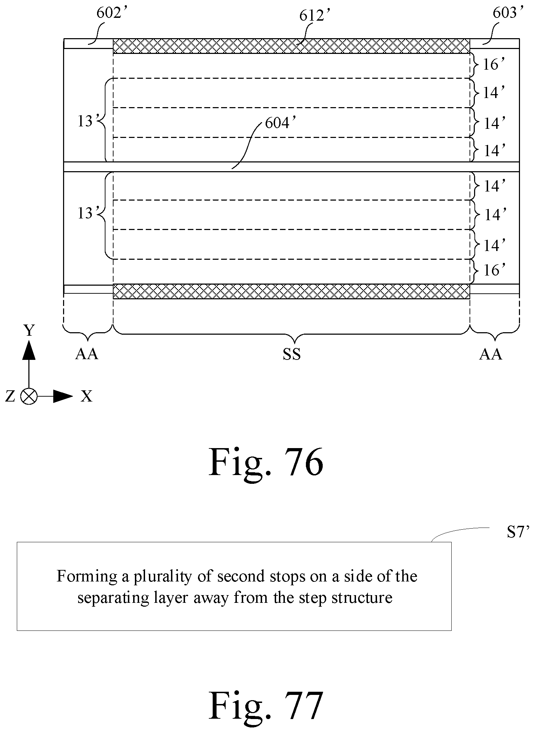

S54', referring to Fig. 76, forming a first sub slit 602', a second sub slit 603' and a second slit 604' extending in the first direction X and through the initial stack structure 101'. In the first direction X, the first sub slit 602' and the second sub slit 603' contact both ends of the second isolation sub portion 612' respectively. In the second direction Y, the second slit 604' is located between two adjacent second isolation sub portions 612'.

In some examples, as shown in Fig. 74, the fabrication method further includes:
S55', referring to Fig. 71, forming the first isolation sub portion 611' in the first sub slit 602', forming the third isolation sub portion 613' in the second sub slit 603' and forming the second isolation structure 62' in the second slit 604'.

The first isolation sub portion 611', the third isolation sub portion 613' and the second isolation sub portion 612' constitute at least a part of the first isolation structure 61'.

In some examples, as shown in Fig. 77, the fabrication method further includes:
S7', referring to Fig. 71, forming a plurality of second stops 70' on a side of the separating layer 30' away from the step structure 13'. The plurality of second stops 70 are disposed in the first direction X and located on the plurality of steps 141' of other staircase structures 14' among the plurality of staircase structures 14' other than the staircase structures 14' on which the first stops 20' are disposed. Each second stop 70' is located on one step 141'.

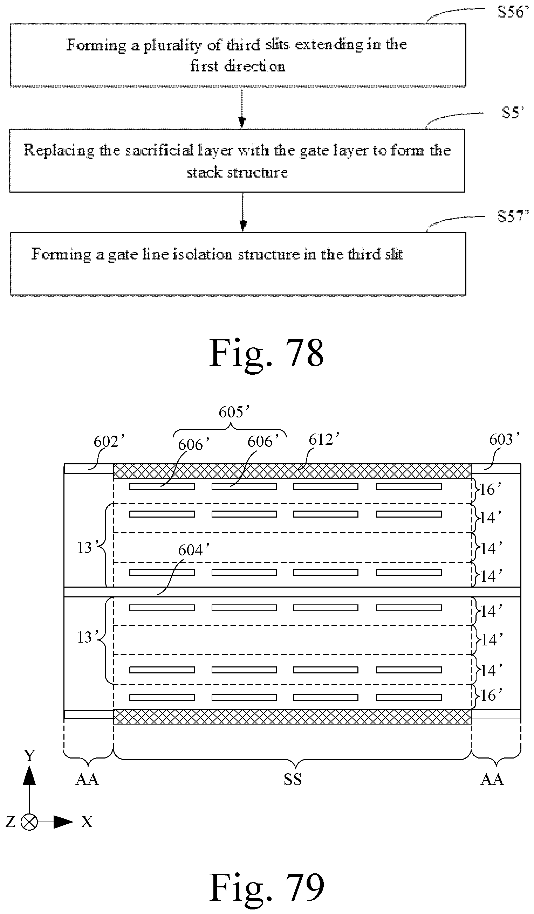

In some examples, as shown in Fig. 78, the fabrication method further includes:
S56', referring to Fig. 79, forming a third slit 605' extending in the first direction X. The third slit 605' extends through the second stop 70' and the initial stack structure 101'. In the first direction X, each third slit 605' includes a plurality of third sub slits 606' separated from each other.

Illustratively, the third slit 605' may be formed simultaneously with the first slit 601', or the third slit 605' may be formed simultaneously with the first sub slit 602', the second sub slit 603' and the second slit 604'.

In some examples, as shown in Fig. 78, the fabrication method further includes:
S57', referring to Fig. 71, forming a gate line isolation structure 80' in the third slit 605'.

Illustratively, it is possible to form the plurality of third slits 605' extending in the first direction X before replacing the sacrificial layer 120' with the gate layer 11 to form the stack structure 10' in the operation S5'. It is possible to form the gate line isolation structure 80' in the third slit 605' after the operation S5'.

Thus, in the process of replacing the sacrificial layer 110' with the gate layer 11', it is possible to replace the material for the second stops 70' with a material same as the gate layer 11' using the plurality of third slits 505'.

S6', forming a plurality of contact posts 50'. The contact post 50' extends through the protection layer 40', the first stop 20' and the separating layer 30' and is connected with the gate layer 11' in the step 141' corresponding to the first stop 20'.

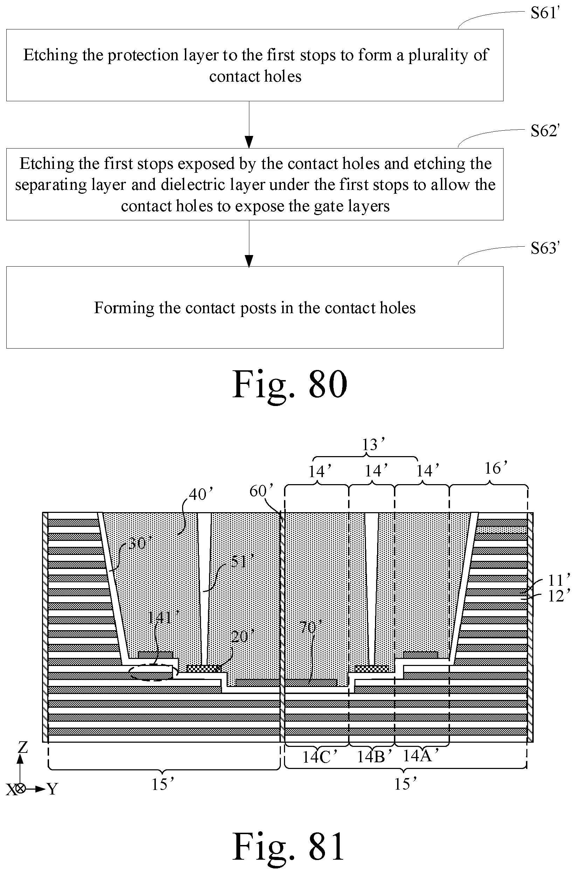

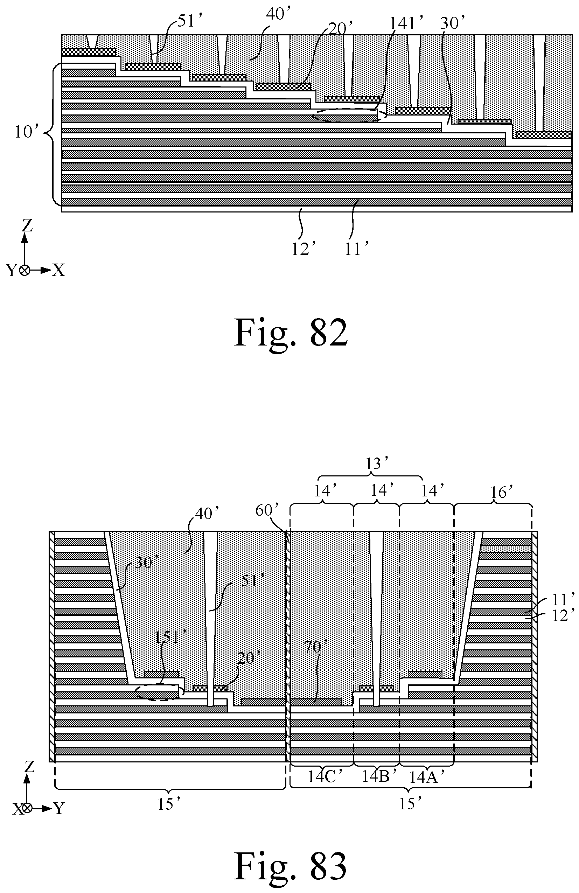

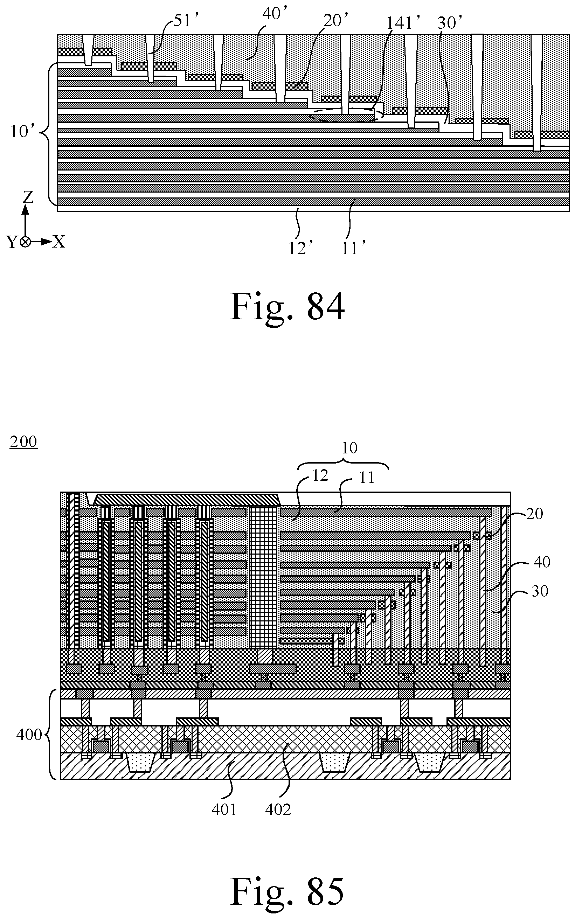

Illustratively, referring to Fig. 80, S6' of forming the plurality of contact posts 50' includes operations S61'-S63':
S61', referring to Figs. 81 and 82, etching the protection layer 40' to the first stops 20', thereby forming the plurality of contact holes 51' .
S62', referring to Figs. 83 and 84, etching the first stop 20' exposed by the contact hole 51' and etching the separating layer 30' and dielectric layer 12' under the first stop 20' to allow the contact hole 51' to expose the gate layer 11'.
S63', referring to Fig. 19A, forming the contact post 50' in the contact hole 51'.

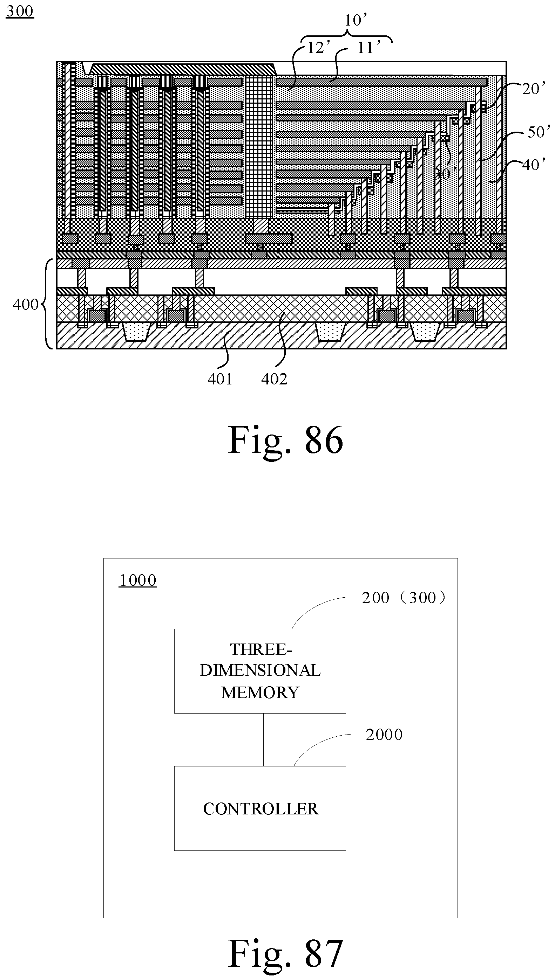

In some examples, referring to Figs. 85 and 86, the three-dimensional memory 200 (or three-dimensional memory 300) may further include a peripheral device 400.

Illustratively, referring back to Figs. 85 and 86, the peripheral device 400 includes a substrate 401 and a peripheral circuit layer 402.

There are many types of the above-described peripheral circuit layer 402, which may be selected according to practical demands. The above-described peripheral circuit layer 402 may include for example a page buffer, a decoder (such as a row decoder and a column decoder), a sense amplifier, a driver (such as a word line driver), or any active or passive components of a circuit such as a transistor, a diode, a resistor and a capacitor.

The above-described peripheral circuit layer 402 may include for example a plurality of transistors. Illustratively, among the plurality of transistors, at least a part of the transistors is formed in the substrate 401 (e.g., under the top surface of the substrate 401) and/or directly on the substrate 401.

Furthermore, the above-described peripheral circuit layer 402 may further include any other circuits compatible with high level logic processes. Illustratively, the peripheral circuit layer 402 includes a logic circuit such as a processor and a programmable logic device and/or a storage circuit such as a static random-access memory.

As shown in Fig. 87, some examples of the present disclosure provide a memory system 1000 including a three-dimensional memory 200 (three-dimensional memory 300) and a controller 2000. The controller 2000 is coupled to the three-dimensional memory 200 (three-dimensional memory 300) to control the three-dimensional memory 300 to store data.

The memory system 1000 may be integrated into various types of storage devices such as being included in the same package (such as Universal Flash Storage (UFS)) or Embedded Multi Media Card (eMMC) package. That is, the memory system 1000 can be applied to and packaged in different types of electronic products such as a mobile phone (e.g., a handset), a desktop computer, a tablet, a notebook computer, a server, an on-vehicle device, a gaming console, a printer, a positioning device, a wearable device, a smart sensor, a mobile power source, a virtual reality (VR) device, an argument reality (AR) device, or any other suitable electronic devices having a storage therein.

In some examples, referring to Fig. 87, the memory system 1000 includes a controller 2000 and a three-dimensional memory 200 (or three-dimensional memory 300) and may be integrated into a memory card.

The memory card includes any one of a PC card (PCMCIA, International Association of Personal Computer Memory Cards), a Compact Flash (CF) card, a Smart Media (SM) card, a memory stick, a Multimedia Card (MMC), a Secure Digital Memory Card (SD) or a UFS.

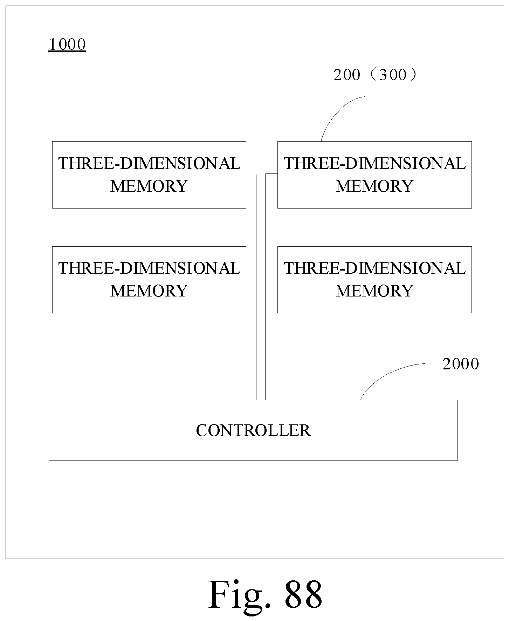

In some other examples, referring to Fig. 88, the memory system 1000 includes a controller 2000 and a plurality of three-dimensional memories 200 (or three-dimensional memories 300) and is integrated in a solid state drive (SSD).

In the memory system 1000, in some examples, the controller 2000 is configured to operate in low duty cycle environment, such as SD cards, CF cards, Universal Serial Bus (USB) flash drives, or other media used in electronic devices such as personal calculators, digital cameras and mobile phones.

In some other examples, the controller 2000 is configured to operate in high duty cycle environment SSDs or eMMCs that are used as data stores of the mobile devices such as smart phones, tablet and notebook computers and enterprise memory arrays.

In some examples, the controller 2000 may be configured to manage the data stored in three-dimensional memory 200 (or three-dimensional memory 300) and communicate with external equipment (such as a host). In some examples, the controller 2000 may be configured to control operations of the three-dimensional memory 200 (or three-dimensional memory 300), such as read, erase, and program operations. In some examples, the controller 2000 may also be configured to manage various functions with respect to the data stored or to be stored in the memory 200 (or three-dimensional memory 300) including at least one of bad-block management, garbage collection, logical-to-physical address conversion, wear leveling, etc. In some examples, the controller 2000 is further configured to process error correction codes with respect to the data read from or written to the three-dimensional memory 200 (or three-dimensional memory 300).

Of course, any other suitable functions may be performed by the controller 2000 as well, for example, formatting the three-dimensional memory 200 (or three-dimensional memory 300). For example, the controller 2000 may communicate with an external equipment such as a host through at least one of various interface protocols.

It is to be noted that the interface protocols include at least one of USB protocol, MMC protocol, peripheral component interconnection (PCI) protocol, PCI-express (PCI-E) protocol, advanced technology attachment (ATA) protocol, serial-ATA protocol, parallel-ATA protocol, small computer small interface (SCSI) protocol, enhanced small disk interface (ESDI) protocol, integrated drive electronics (IDE) protocol and Firewire protocol.

Some examples of the present disclosure provide an electronic apparatus. The electronic apparatus may be any one of a mobile phone, a desktop computer, a tablet, a notebook computer, a server, an on-vehicle device, a wearable device such as a smart watch, a smart bracelet and a pair of smart glasses, a mobile power source, a game console, a digital multimedia player etc.

The electronic apparatus may include the memory system 1000 as described above, and may further include at least one of a central processing unit and a cache.

What have been described above are only implementations of the present disclosure. However, the scope of the present invention is not limited thereto, and variations or substitutions that easily occur to one skilled in the art in the scope disclosed in the present disclosure should be encompassed in the scope of the present disclosure. Therefore, the scope of the present disclosure should be determined by the scope of the claims.

## Claims

1. A three-dimensional memory, comprising:
a stack structure comprising gate layers and dielectric layers disposed alternately; the stack structure comprising a step structure comprising a plurality of staircase structures disposed in a first direction and having different heights in a second direction; the staircase structure comprising a plurality of steps; the first direction being perpendicular to the second direction;
a plurality of first stops disposed in the first direction and located on the plurality of steps of at least one of the staircase structures, with each of the plurality of first stops disposed on the corresponding step of the plurality of steps;
a protection layer covering the step structure and the first stops; and
a plurality of contact posts, each of which extends through the protection layer and the first stop and is connected with the gate layer in the step corresponding to the first stop.

2. The three-dimensional memory of claim 1, further comprising:
isolation structures extending in the first direction and through the stack structure; the isolation structures dividing the stack structure into a plurality of memory blocks, with each memory block comprising the step structure;
wherein the staircase structures where the first stops are located are disposed at intervals with the isolation structures.

3. The three-dimensional memory of claim 2, wherein in the second direction, the memory block comprises a first staircase structure, a second staircase structure and a third staircase structure, with the first stops disposed on the plurality of steps of the second staircase structure.

4. The three-dimensional memory of claim 2, wherein in the second direction, the memory block comprises a first staircase structure and a second staircase structure, the first staircase structure being disposed at intervals with the isolation structure, and the first stops being disposed on the plurality of steps of the first staircase structure.

5. The three-dimensional memory of claim 2, wherein each memory block further comprises a sidewall;
the isolation structures comprise a first isolation structure and a second isolation structure;
in the second direction, the first isolation structure is located between two adjacent sidewalls in different memory blocks; the second isolation structure is located between two adjacent step structures; and in the second direction, the step structures in two memory blocks adjacent to the second isolation structure are disposed symmetrically.

6. The three-dimensional memory of claim 5, wherein in the second direction, and along a direction from the first isolation structure toward the second isolation structure, the plurality of staircase structures in the memory block have heights decreasing gradually.

7. The three-dimensional memory of claim 5, wherein in the second direction, two staircase structures adjacent to both sides of the second isolation structure have same heights.

8. The three-dimensional memory of claim 2, further comprising:
a plurality of second stops disposed in the first direction and located on the plurality of steps of other staircase structures among the plurality of staircase structures other than the staircase structures on which the first stops are disposed;
wherein the protection layer further covers the second stops and at least a part of the protection layer is located between the second stop and the step adjacent to the second stop.

9. The three-dimensional memory of claim 8, wherein the memory block comprises a plurality of gate line isolation structures each extending through the second stop and the stack structure and extending in the first direction, each gate line isolation structure comprises a plurality of sub isolation structures disposed at intervals;
wherein a material for the second stop is same as a material for the gate layer.

10. The three-dimensional memory of any one of claims 1-9, wherein the material for the first stop comprises silicon nitride.

11. The three-dimensional memory of any one of claims 1-9, wherein in a third direction, a thickness of the first stop is same as a thickness of the gate layer of a previous step; the previous step being adjacent to and higher than the step corresponding to the first stop;
wherein the third direction is perpendicular to the first direction and the second direction.

12. The three-dimensional memory of claim 8, wherein the first stop comprises carbon doped silicon nitride.

13. The three-dimensional memory of claim 12, wherein a material for the second stop is same as the material for the first stop.

14. The three-dimensional memory of claim 8, wherein a thickness of the second stop is greater than a thickness of the gate layer, and the second stop comprises an insulating material.

15. The three-dimensional memory of claim 1, wherein at least a part of the protection layer is located between the first stop and the step adjacent to the first stop.

16. The three-dimensional memory of claim 1, further comprising a separating layer covering the step structures and located between the step structure and the first stop.

17. A fabrication method of a three-dimensional memory, comprising:
forming an initial stack structure comprising sacrificial layers and dielectric layers disposed alternately; the initial stack structure comprising a step structure comprising a plurality of staircase structures disposed in a first direction and having different heights in a second direction; the staircase structure comprising a plurality of steps; the first direction being perpendicular to the second direction;
forming a plurality of first stops on the plurality of steps of at least one of the staircase structures; the plurality of first stops being disposed in the first direction, with each of the plurality of first stops disposed on one of the plurality of steps;
forming a protection layer covering the step structures and the first stops, at least a part of the protection layer being located between the first stop and the step adjacent to the first stop;
replacing the sacrificial layers with gate layers to form a stack structure; and
forming a plurality of contact posts each of which extends through the protection layer and the first stop and is electrically connected with the gate layer in the step corresponding to the first stop.

18. The fabrication method of claim 17, wherein the forming the plurality of first stops on the plurality of steps of at least one of the staircase structures comprises:
etching the uppermost sacrificial layer and dielectric layer of each step to form the plurality of first stops.

19. The fabrication method of claim 17, further comprising:
forming a first slit extending in the first direction and through the initial stack structure; the first slit dividing the initial stack structure into a plurality of initial memory blocks, each of which comprises the step structure; and
forming an isolation structure in the first slit.

20. The fabrication method of claim 17, further comprising:
forming a second isolation sub portion extending in the first direction and through the initial stack structure;
forming a first sub slit, a second sub slit and a second slit extending in the first direction and through the initial stack structure; the first sub slit and the second sub slit contacting both ends of the second isolation sub portion respectively in the first direction; and the second slit being located between two adjacent second isolation sub portions in the second direction; and
forming a first isolation sub portion in the first sub slit, forming a third isolation sub portion in the second sub slit and forming a second isolation structure in the second slit;
wherein the first isolation sub portion, the third isolation sub portion and the second isolation sub portion constitute at least a part of the first isolation structure.

21. The fabrication method of claim 17, further comprising:
forming a plurality of second stops on the plurality of steps of other staircase structures among the plurality of staircase structures other than the staircase structures on which the first stops are disposed; each second stop being disposed on one step.

22. The fabrication method of claim 21, further comprising:
forming a plurality of third slits extending in the first direction; the third slit extending through the second stop and the initial stack structure; each of the third slits comprising a plurality of third sub slits separated from each other in the first direction; and
forming gate line isolation structures in the third slits.

23. The fabrication method of any one of claims 17-22, wherein the forming the plurality of contact posts comprises:
etching the protection layer to the first stops to form a plurality of contact holes;
etching the first stops exposed by the contact holes and etching the dielectric layers under the first stops to allow the contact holes to expose the gate layers; and
forming the contact posts in the contact holes.

24. A memory system, comprising:
a controller; and
the three-dimensional memory of any one of claims 1-16;
wherein the controller is coupled to the three-dimensional memory and configured to control the three-dimensional memory to store data.

25. An electronic apparatus, comprising:
the memory system of claim 24.
